(19) Europäisches Patentamt / European Patent Office / Office européen des brevets

(11) **EP 4 358 406 A2**

(12) **DEMANDE DE BREVET EUROPEEN**

(43) Date de publication:
**24.04.2024 Bulletin 2024/17**

(21) Numéro de dépôt: **23201334.2**

(22) Date de dépôt: **03.10.2023**

(51) Classification Internationale des Brevets (IPC):
**H03K 17/18** (2006.01)   **G01R 31/26** (2020.01)
**H01L 27/07** (2006.01)   **H02H 5/04** (2006.01)

(52) Classification Coopérative des Brevets (CPC):
**H03K 17/18; G01R 31/2628; H01L 21/8252;**
**H01L 27/0629; H01L 27/0802; H02H 5/042;**
H01L 28/20; H01L 29/2003; H01L 29/41758;
H01L 29/41766; H01L 29/42356; H01L 29/7786;
H03K 2017/0806

(84) Etats contractants désignés:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Etats d'extension désignés:
**BA**
Etats de validation désignés:
**KH MA MD TN**

(30) Priorité:  **17.10.2022  FR 2210661**

(71) Demandeur: **STMicroelectronics (Rousset) SAS**
**13790 Rousset (FR)**

(72) Inventeurs:
• **BOURGUINE, Loic**
  **13790 CHATEAUNEUF LE ROUGE (FR)**
• **ESTEVE, Lionel**
  **13111 COUDOUX (FR)**

(74) Mandataire: **Cabinet Beaumont**
**4, Place Robert Schuman**
**B.P. 1529**
**38025 Grenoble Cedex 1 (FR)**

(54)   **CIRCUIT DE PROTECTION CONTRE LES SURCHAUFFES**

(57)     La présente description concerne un circuit de protection contre les surchauffes (1800) formé dans et sur un substrat semiconducteur monolithique ayant une face recouverte d'une couche de Nitrure de Gallium, comprenant :
- une première résistance (R1802) ayant un premier coefficient de température positif et étant disposée dans ladite couche de Nitrure de Gallium ; et
- une deuxième résistance (R1801) ayant un deuxième coefficient de température différent du premier coefficient.

**Fig. 18**

**Description**

Domaine technique

La présente description concerne de façon générale les systèmes et dispositifs électroniques, et plus particulièrement les systèmes et dispositifs électroniques formées à partir d'une structure de Nitrure de Gallium (GaN).

Technique antérieure

Il est classique de former des systèmes et des dispositifs électroniques à partir de substrat en silicium, mais d'autres matériaux semiconducteurs peuvent être utilisés. En particulier, des structures comprenant du Nitrure de Gallium (GaN) peuvent être utilisées.

Il serait souhaitable de pouvoir améliorer, au moins en partie, certains aspects des systèmes et dispositifs électroniques formées à partir dans et sur des structures comprenant du Nitrure de Gallium.

Résumé de l'invention

Il existe un besoin pour des systèmes et dispositifs électroniques formés dans et sur des structures comprenant du Nitrure de Gallium.

Il existe un besoin pour des systèmes et dispositifs électroniques comprenant des transistors formés dans et sur des structures comprenant du Nitrure de Gallium.

Un mode de réalisation pallie tout ou partie des inconvénients des systèmes et dispositifs électroniques connus.

Selon un premier aspect, un mode de réalisation prévoit un dispositif électronique formé dans et sur un substrat semiconducteur monolithique ayant une face recouverte d'une couche de Nitrure de Gallium, comprenant au moins un transistor de puissance HEMT de type e-mode adapté à recevoir une tension maximale de 650 V entre son drain et sa source, et un circuit analogique de commande dudit transistor de puissance.

Selon un mode de réalisation, le circuit analogique de commande comprend un circuit de pilotage dudit transistor de puissance.

Selon un mode de réalisation, le circuit analogique de commande comprend au moins un circuit logique.

Selon un mode de réalisation, le circuit analogique de commande comprend au moins un circuit régulateur de tension .

Selon un mode de réalisation, le circuit analogique de commande comprend au moins un circuit régulateur de haute tension adapté à recevoir une tension maximale de 400 V.

Selon un mode de réalisation, le circuit analogique de commande comprend un circuit de protection contre les surchauffes.

Selon un mode de réalisation, le circuit analogique de commande comprend un circuit de protection contre les surintensités.

Selon un mode de réalisation, le dispositif comprend, en outre, des plots de connexion d'entrée et de sortie.

Selon un mode de réalisation, au moins deux niveaux de métallisations sont formées sur ladite couche de Nitrure de Gallium.

Selon un mode de réalisation, au moins trois niveaux de métallisations sont formées sur ladite couche de Nitrure de Gallium.

Un autre mode de réalisation prévoit un circuit intégré comprenant un dispositif décrit précédemment.

Selon un mode de réalisation, le circuit est un convertisseur de puissance.

Selon un mode de réalisation, le circuit est une alimentation à découpage.

Selon un deuxième aspect, un mode de réalisation prévoit un circuit de protection contre les surchauffes formé dans et sur un substrat semiconducteur monolithique ayant une face recouverte d'une couche de Nitrure de Gallium, comprenant :

- une première résistance ayant un premier coefficient de température positif et étant disposée dans ladite couche de Nitrure de Gallium ; et
- une deuxième résistance ayant un deuxième coefficient de température différent du premier coefficient.

Selon un mode de réalisation, la deuxième résistance est disposée dans ledit substrat, et dans lequel ledit deuxième coefficient est égal à zéro.

Selon un mode de réalisation, la deuxième résistance est disposée dans ladite couche de Nitrure de Gallium.

Selon un mode de réalisation, ledit deuxième coefficient est positif.

Selon un mode de réalisation, ledit deuxième coefficient est négatif.

Selon un mode de réalisation, ladite deuxième résistance est en un alliage de Silicium et de Chrome.

Selon un mode de réalisation, le circuit comprend, en outre, un circuit comparateur adapté à comparer une premier tension prise aux bornes de la première résistance à une deuxième tension de référence.

Selon un mode de réalisation, la tension de référence est adaptée à être fournie par un pont diviseur de tension.

Selon un mode de réalisation, l'impédance de la première résistance est adapté à être ajustée.

Selon un mode de réalisation, la première résistance est formée par un circuit comprenant au moins un fusible.

Un autre mode de réalisation prévoit un dispositif électronique formé dans et sur un substrat semiconducteur monolithique ayant une face recouverte d'une couche de Nitrure de Gallium, comprenant un circuit de protection contre les surchauffes décrit précédemment.

Selon un mode de réalisation le dispositif comprend, en outre, au moins un transistor de puissance HEMT de type e-mode adapté à recevoir une tension maximale de 650 V entre son drain et sa source.

Selon un mode de réalisation, ledit transistor de puissance est formée par au moins deux assemblages de transistors HEMT de type e-mode, et la première résistance est formée entre deux desdits assemblages.

Selon un troisième aspect, un mode de réalisation prévoit un circuit de pilotage d'un premier transistor de puissance HEMT de type e-mode adapté à recevoir une tension maximale de 650 V entre son drain et sa source, ledit circuit étant formé dans et sur un substrat semiconducteur monolithique ayant une face recouverte d'une couche de Nitrure de Gallium, et comprenant au moins un deuxième transistor de type e-mode adapté à transmettre directement une tension de commande à la grille du premier transistor et dont l'aire est supérieure à 5 mm2.

Selon un mode de réalisation, ledit deuxième transistor a une aire comprise entre 10 et 15 mm2.

Selon un mode de réalisation, ledit deuxième transistor est composé d'un assemblage de plusieurs transistors de type e-mode.

Un autre mode de réalisation prévoit un dispositif comprenant ledit premier transistor de puissance et un circuit de pilotage décrit précédemment.

Selon un mode de réalisation, le deuxième transistor du circuit de pilotage comprend une région de drain en contact direct avec une région de grille du premier transistor de puissance.

Selon un quatrième aspect, un mode de réalisation prévoit un circuit régulateur de tension formé dans et sur un substrat semiconducteur monolithique ayant une face recouverte d'une couche de Nitrure de Gallium, comprenant :

- entre une première borne et une deuxième borne, une première résistance et un premier transistor HEMT de type d-mode ; et

- entre la première borne et la troisième borne, un deuxième transistor HEMT de type d-mode,

dans lequel le point milieu entre la première résistance et le premier transistor est reliée aux grilles des premier et deuxième transistors.

Selon un mode de réalisation, le circuit comprend, en outre, entre la deuxième borne et une borne de référence, une diode Zener.

Selon un mode de réalisation, la diode Zener est formée sur une portion du substrat semiconducteur qui n'est pas recouverte par la couche de Nitrure de Gallium.

Selon un mode de réalisation, la deuxième borne ou par la troisième borne sont adaptées à fournir une tension d'alimentation.

Selon un mode de réalisation, le circuit comprend, en outre, entre la première résistance et le premier transistor, un troisième transistor HEMT de type d-mode dont la grille est reliée au noeud milieu entre la première résistance et le troisième transistor.

Selon un mode de réalisation, le circuit comprend, en outre, entre la première borne et un premier noeud adapté à fournir une tension d'alimentation, un cinquième transistor HEMT de type d-mode dont la grille est relié à la grille du troisième transistor.

Selon un mode de réalisation, le circuit comprend, en outre, entre la première borne et un deuxième noeud adapté à fournir une tension d'alimentation, un sixième transistor HEMT de type d-mode dont la grille est relié à la grille du premier transistor.

Selon un mode de réalisation, le circuit comprend, en outre, entre la première borne et la deuxième borne un septième transistor HEMT et une deuxième résistance, le drain du septième transistor étant relié à la première borne, la source du septième transistor étant relié à une première borne de ladite deuxième résistance, et une deuxième borne de ladite deuxième résistance étant relié à la deuxième borne.

Selon un mode de réalisation, le septième transistor est de type d-mode et a sa grille relié à son drain.

Selon un mode de réalisation, le septième transistor est de type e-mode, et est adapté à recevoir sur sa grille une tension de polarisation.

Un autre mode de réalisation prévoit un circuit de régulation de haute tension comprenant le circuit régulateur de tension décrit précédemment.

Selon un mode de réalisation, le circuit comprend, en outre, le circuit régulateur de tension décrit précédemment.

Selon un mode de réalisation, le circuit comprend :

- entre une quatrième borne et ladite première borne, une première diode, dont l'anode est reliée à la quatrième borne et la cathode est reliée à la première borne ;
- entre une cinquième borne et la première borne, un huitième transistor HEMT de type d-mode et une deuxième diode ;
- entre une cinquième borne et une sixième borne, une troisième résistance et une bascule,

la grille du huitième transistor étant reliée au point milieu entre ladite troisième résistance et ladite bascule.

Selon un mode de réalisation, ledit huitième transistor est adaptée à être commandé par un circuit de commande comprenant :

- un neuvième transistor HEMT de type e-mode, dont le drain est relié à la grille du huitième transistor, et la source est reliée à la sixième borne ;
- un circuit comparateur adapté à fournir une tension de commande à la grille dudit neuvième transistor, et adapté à comparer la tension de la première borne à une tension de référence ;
- un circuit adapté à fournir ladite tension de référence.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

La figure 1 représente, très schématiquement, une structure comprenant du Nitrure de Gallium ;

la figure 2 comprend deux vues (A) et (B) illustrant un premier type de transistor formé dans et sur une structure comprenant du Nitrure de Gallium ;

la figure 3 représente comprend deux vues (A) et (B) illustrant un deuxième type de transistor formé dans une structure comprenant du Nitrure de Gallium ;

la figure 4 représente, très schématiquement et sous forme de blocs, un mode de réalisation d'un dispositif électronique formé dans et sur une structure comprenant du Nitrure de Gallium ;

la figure 5 représente une vue de dessus schématique d'une partie du mode de réalisation de la figure 4 ;

la figure 6 représente une vue de dessus détaillée du mode de réalisation de la figure 4 ;

la figure 7 comprend une vue (A) représentant un schéma électrique d'un premier mode de réalisation d'un circuit régulateur de tension du mode de réalisation de la figure 4, et une vue (B) représentant une vue en coupe d'une structure formant le premier mode de réalisation du circuit régulateur de tension ;

la figure 8 représente un schéma électrique d'un deuxième mode de réalisation d'un circuit régulateur de tension du mode de réalisation de la figure 4 ;

la figure 9 représente un schéma électrique d'un troisième mode de réalisation d'un circuit régulateur de tension du mode de réalisation de la figure 4 ;

la figure 10 représente un schéma électrique d'un quatrième mode de réalisation d'un circuit régulateur de tension du mode de réalisation de la figure 4 ;

la figure 11 représente un schéma électrique d'un cinquième mode de réalisation d'un circuit régulateur de tension du mode de réalisation de la figure 4 ;

la figure 12 représente un schéma électrique d'un sixième mode de réalisation d'un circuit régulateur de tension du mode de réalisation de la figure 4 ;

la figure 13 représente un schéma électrique d'un septième mode de réalisation d'un circuit régulateur de tension du mode de réalisation de la figure 4 ;

la figure 14 représente un schéma électrique d'un huitième mode de réalisation d'un circuit régulateur de tension du mode de réalisation de la figure 4 ;

la figure 15 représente un schéma électrique d'un premier mode de réalisation d'un circuit régulateur de haute tension du mode de réalisation de la figure 4 ;

la figure 16 représente un schéma électrique d'un deuxième mode de réalisation d'un circuit régulateur de haute tension du mode de réalisation de la figure 4 ;

la figure 17 représente un schéma électrique d'un exemple de réalisation d'un comparateur du mode de réalisation de la figure 16 ;

la figure 18 représente un schéma électrique d'un premier mode de réalisation d'un circuit de protection contre les surchauffes du mode de réalisation de la figure 4 ;

la figure 19 représente un schéma électrique d'un deuxième mode de réalisation d'un circuit de protection contre les surchauffes du mode de réalisation de la figure 4 ;

la figure 20 représente une vue de dessus schématique du mode de réalisation de la figure 4 ;

la figure 21 comprend deux vues représentant un schéma électrique d'un troisième mode de réalisation d'un circuit de protection contre les surchauffes du mode de réalisation de la figure 4 ;

la figure 22 est une vue en coupe représentant un fusible du mode de réalisation de la figure 21 ;

la figure 23 représente un schéma électrique d'un premier mode de réalisation d'un circuit de pilotage du mode de réalisation de la figure 4 ;

la figure 24 représente une vue de dessus schématique d'une portion du circuit de pilotage de la figure 23 ;

la figure 25 représente un schéma électrique d'un deuxième mode de réalisation d'un circuit de pilotage du mode de réalisation de la figure 4 ;

la figure 26 représente un schéma électrique d'un troisième mode de réalisation d'un circuit de pilotage du mode de réalisation de la figure 4 ;

la figure 27 représente un schéma électrique d'un mode de réalisation d'un circuit de protection contre les surintensités du mode de réalisation de la figure 4 ;

la figure 28 comprend des chronogrammes illustrant le fonctionnement du circuit de la figure 27 ;

la figure 29 représente une vue de dessus détaillé du mode de réalisation de la figure 4 illustrant le positionnement du circuit de pilotage de la figure 27 ;

la figure 30 représente une vue en coupe schématiquement d'un premier mode de réalisation d'une borne de connexion du dispositif de la figure 4 ;

la figure 31 représente une vue en coupe schématiquement d'un deuxième mode de réalisation d'une borne de connexion du dispositif de la figure 4 ;

la figure 32 représente une vue en coupe schématiquement d'un troisième mode de réalisation d'une borne de connexion du dispositif de la figure 4 ;

la figure 33 représente deux vues (A) et (B), schématiquement et partiellement sous forme de blocs, un schéma électrique d'un premier mode de réalisation d'une application du mode de réalisation de la figure 4 et des chronogrammes illustrant le fonctionnement de ce premier mode de réalisation ;

la figure 34 représente, schématiquement et partiellement sous forme de blocs, un schéma électrique d'un deuxième mode de réalisation d'une application du mode de réalisation de la figure 4 ;

la figure 35 représente des chronogrammes illustrant le fonctionnement du mode de réalisation de la figure 34 ; et

la figure 36 représente, schématiquement et partiellement sous forme de blocs, un schéma électrique d'un troisième mode de réalisation d'une application du mode de réalisation de la figure 4.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

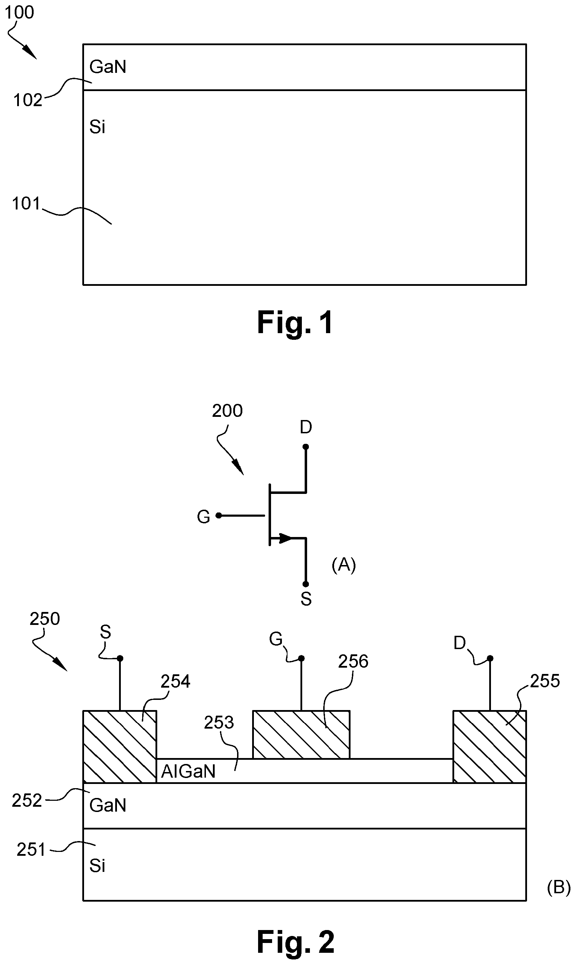

La figure 1 est une vue en coupe représentant très schématiquement une structure semiconductrice 100 comprenant du Nitrure de Gallium.

La structure 100 est généralement composée d'un substrat 101 (Si) en un matériau semiconducteur, par exemple un substrat en silicium, recouvert sur une de ses faces d'une couche 102 (GaN) en Nitrure de Gallium (GaN). La couche 102 a une épaisseur comprise entre 0,5 et 5 $\mu$m.

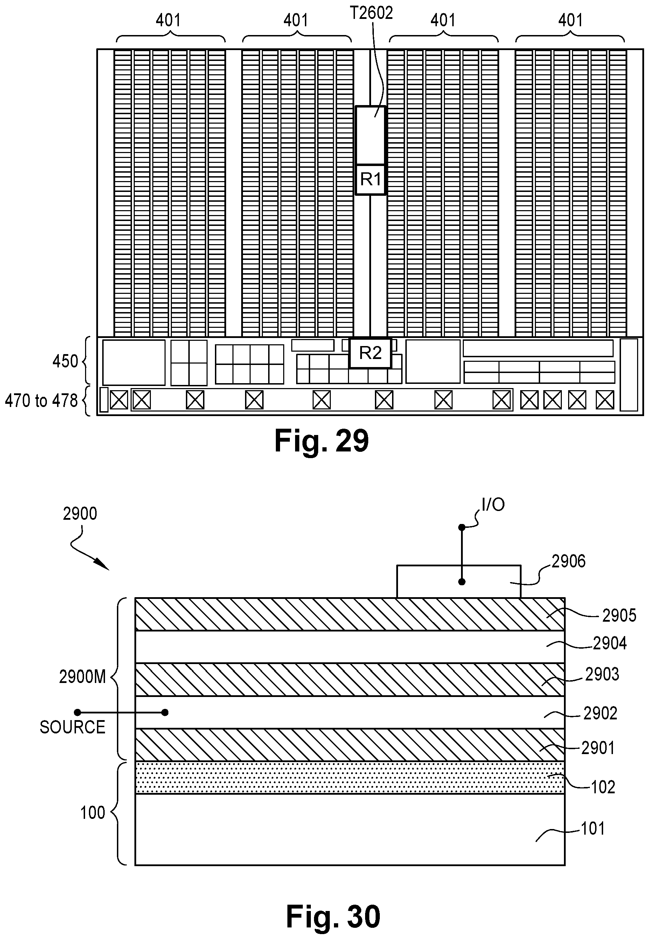

Lorsque la structure 100 est utilisée comme base d'un système ou d'un dispositif électronique, des composants électroniques sont formées dans et sur la couche 102. Des niveaux de métallisations peuvent, en outre, être formés sur la couche 102. Des exemples de niveaux de métallisations sont décrits en relation avec les figures 29 à 31.

La figure 2 comprend deux vues (A) et (B) illustrant un premier type de transistor 200 formé dans une structure comprenant du Nitrure de Gallium. La vue (A) représente un schéma électrique du transistor 200, et la vue (B) représente une vue en coupe d'une structure 250 formant le transistor 200.

Le transistor 200 est un transistor à électron à haute mobilité (High Electron Mobility Transistor, HEMT), aussi appelé transistor à effet de champ à dopage modulé (modulateddoping field effect transistor, MODFET). Ci-après un transistor à élection à haute mobilité est appelé transistor HEMT.

Un transistor HEMT, comme le transistor 200, comprend, une borne de grille, notée G en figure 2, une borne de source, notée S en figure 2, et une borne de drain, notée D en figure 2.

De plus, le transistor 200 est un transistor HEMT à mode de déplétion (depletion mode), appelé ci-après transistor HEMT de type d-mode, ou transistor d-mode. Selon une autre appellation, le transistor 200 est un transistor HEMT de type normalement ON (normally-ON), ou transistor HEMT normalement ON, ou transistor normalement ON. Le schéma électrique du transistor 200 présenté en vue (A) est le schéma électrique qui sera utilisé dans toutes les figures suivantes pour représenter un transistor d-mode ou normalement ON.

En pratique, le transistor 200 peut être obtenu par une structure 250 formée à partir d'une structure du type de la structure 100 décrite en relation avec la figure 1. Ainsi, la structure 250 comprend un substrat 251 (Si) en un matériau conducteur, comme du silicium, dont une face est recouverte par une couche 252 (GaN) en Nitrure de Gallium. La couche 252 en Nitrure de Gallium est partiellement recouverte par une couche 253 (AlGaN) en Nitrure d'Aluminium-Gallium. Une borne de connexion 254 forme la prise de contact de source S du transistor 200. La borne de connexion 254 est formée sur une portion de la couche 252 qui n'est pas recouverte de la couche 253. Une borne de connexion 255 forme la prise de contact de drain D du transistor 200. La borne de connexion 255 est formée sur une portion de la couche 252 qui n'est pas recouverte de la couche 253. Une borne de connexion 256 forme la prise de contact de grille G du transistor 200. La borne de connexion 256 est formée sur une portion de la couche 253, et est disposé entre les plots de connexion 254 et 255.

Le fonctionnement du transistor 200 est le suivant. Lorsque la grille G du transistor 200 est laissé flottante ou qu'une tension positive est appliquée entre sa grille G et sa source S, le transistor 200 est passant au conducteur, d'où son appellation de transistor normalement ON. Pour "fermer" le transistor 200, c'est-à-dire le rendre non conducteur, une tension négative doit être appliquée entre sa grille G et sa source S.

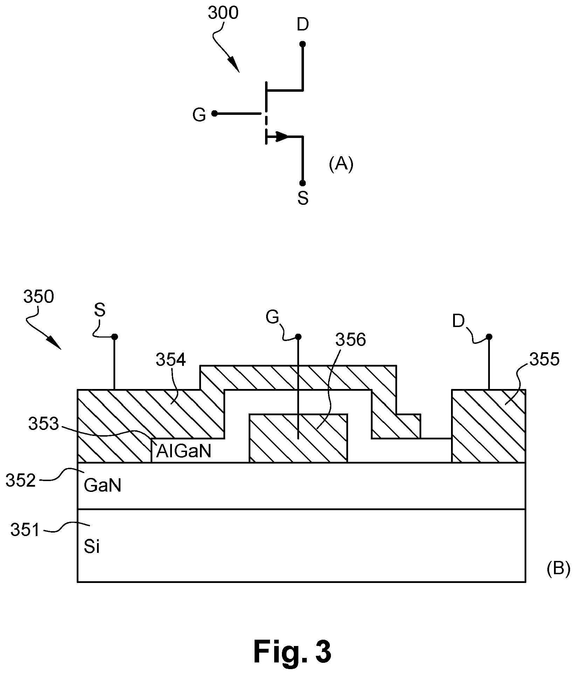

La figure 3 comprend deux vues (A) et (B) illustrant un deuxième type de transistor 300 formé dans une structure comprenant du Nitrure de Gallium. La vue (A) représente un schéma électrique du transistor 300, et la vue (B) représente une vue en coupe d'une structure 350 formant le transistor 300.

Comme le transistor 200 décrit en relation avec la figure 2, le transistor 300 est un transistor à électron à haute mobilité, ou transistor HEMT. Le transistor 300, comprend, une borne de grille, notée G en figure 3, une borne de source, notée S en figure 3, et une borne de drain, notée D en figure 3.

De plus, et à l'inverse du transistor 200 de la figure 2, le transistor 300 est un transistor HEMT à mode de renforcement (enhancement mode), appelé ci-après transistor HEMT de type e-mode, ou transistor e-mode. Selon une autre appellation, le transistor 300 est un transistor HEMT de type normalement OFF (normally-OFF), ou transistor HEMT normalement OFF, ou transistor normalement OFF. Le schéma électrique du transistor 300 présenté en vue (A) est le schéma électrique qui sera utilisé dans toutes les figures suivantes pour représenter un transistor e-mode ou normalement OFF.

En pratique, le transistor 300 peut être obtenu par une structure 350 formée à partir d'une structure du type de la structure 100 décrite en relation avec la figure 1. Ainsi, la structure 350 comprend un substrat 351 (Si) en un matériau conducteur, comme du silicium, dont une face est recouverte par une couche 352 (GaN) en Nitrure de Gallium. La couche 352 en Nitrure de Gallium est partiellement recouverte par une couche 353 (AlGaN) en Nitrure d'Aluminium-Gallium. Une borne de connexion 354 forme la prise de contact de source S du transistor 300. La borne de connexion 354 est formée sur une portion de la couche 352 qui n'est pas recouverte de la couche 353. Une borne de connexion 355 forme la prise de contact de drain D du transistor 300. La borne de connexion 355 est formée sur une portion de la couche 352 qui n'est pas recouverte de la couche 353. Une borne de connexion 356 forme la prise de contact de grille G du transistor 300. La borne de connexion 356 est formée entre la couche 352 et la couche 353 et est disposé entre les plots de connexion 354 et 355. De plus, une portion du plot de connexion 354 recouvre la portion de la couche 353 recouvrant le plot de connexion 356 comme représenté en vue (B) de la figure 3.

Le fonctionnement du transistor 300 est le suivant. Lorsque la grille G du transistor 300 est laissé flottante ou qu'une tension négative est appliquée entre sa grille G et sa source S, le transistor 300 n'est pas conducteur ou non passant, d'où son appellation de transistor normalement OFF. Pour "ouvrir" le transistor 300, c'est-à-dire le rendre conducteur, une tension positive doit être appliquée entre sa grille G et sa source S.

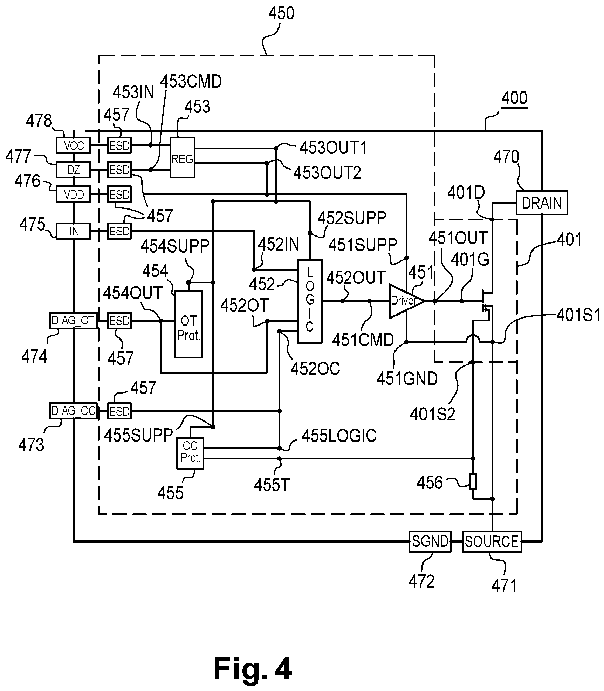

La figure 4 représente, très schématiquement et sous forme de blocs, un mode de réalisation d'un dispositif électronique 400 formé dans et sur une structure du type de la structure décrite en relation avec la figure 1.

Selon un mode de réalisation, le dispositif 400 est formé entièrement dans et sur un structure du type de la structure 100 décrite en relation avec la figure 1, c'est-à-dire une structure comprenant du Nitrure de Gallium (GaN), et plus particulièrement, une structure composée d'un substrat semiconducteur ayant une face recouverte d'une couche de Nitrure de Gallium. Autrement dit, le dispositif 400 est formé entièrement dans et sur une structure monolithique du type de la structure 100 décrite en relation avec la figure 1.

Selon un mode de réalisation, le dispositif 400 est un dispositif électronique adapté à supporter des hautes tensions, c'est-à-dire des tensions allant jusqu'à 650 V. Pour cela, le dispositif 400 comprend un transistor de puissance 401 et un circuit analogique de commande 450 du transistor de puissance 401.

Le transistor de puissance 401 est un transistor HEMT à mode d'émission, ou transistor e-mode, ou transistor normalement OFF comprenant une borne de drain 401D, deux bornes de source 401S1 et 401S2, et une borne de grille 401G. La borne de source 401S1 est, en pratique, disposée entre la borne de source 401S2 et la borne de grille 401G du transistor 401. Le transistor de puissance 401 est dimensionnée pour supporter une tension maximale de l'ordre de 650 V sa borne de drain 401D et sa borne de source 401S1 ou 401S2.

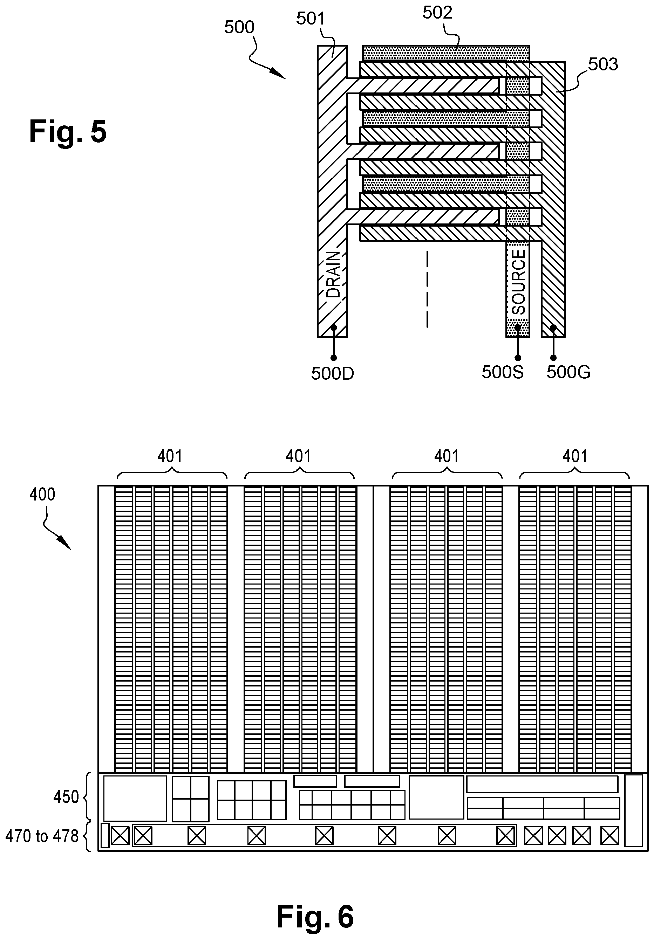

En pratique, le transistor de puissance 401 est un assemblage de plusieurs transistors e-mode en parallèle. Un exemple d'assemblage pouvant formé le transistor 401 est décrit en relation avec la figure 5.

Le circuit analogique de commande 450 est adapté à commander le transistor de puissance 401. Le circuit 450 comprend :

- un circuit de pilotage 451 (DRIVER) du transistor 401 ;
- des circuits logiques 452 (LOGIC) ;
- des circuits régulateurs de tension 453 (REG) ;
- un circuit de protection contre les surchauffes 454 (OT Prot) ;
- un circuit de protection contre les surintensités 455 (OC Prot) ;
- une résistance 456 ; et
- un ou plusieurs circuits de protection contre les décharges électrostatiques 457 (ESD).

Le dispositif 400 comprend, en outre, des bornes de connexions d'entrée et de sortie, ou plot de connexion d'entrée et de sortie, représentées en figure 4 par des blocs disposés sur la ligne délimitant le bloc formant le dispositif 400. Les bornes de connexion d'entrée et de sortie comprennent :

- une borne 470 (DRAIN) de drain du transistor de puissance 401 reliée, de préférence connectée, à la borne 401D ;
- une borne 471 (SOURCE) de source du transistor de puissance 401 reliée, de préférence connectée, à la borne 401S2 ;
- une borne 472 (SGND) de référence ;
- une borne 473 (DIAG_OC) de test des surintensités ;
-- une borne 474 (DIAG_OT) de test des surchauffes ;
- une borne 475 (IN) de commande d'entrée ;
- une borne 476 (VDD) d'alimentation délivrant une tension d'alimentation du circuit de pilotage 451 ;
- une borne 477 (DZ) de commande et de fourniture d'une tension d'alimentation ; et
- une borne 478 (VCC) d'alimentation délivrant une tension d'alimentation du dispositif 400.

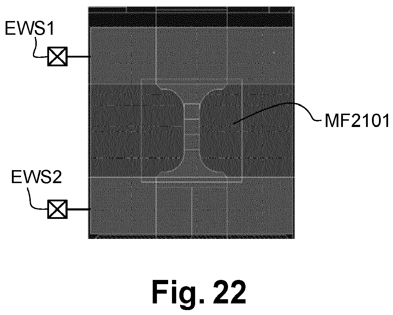

Des modes de réalisation pratiques de bornes de connexion sont décrites en relation avec les figures 29 à 31.
Le circuit de pilotage 451 (DRIVER) du transistor 401 comprend une borne d'alimentation 451SUPP, une borne d'alimentation de référence 451GND, une borne de commande 451CMD, ou borne d'entrée 451CMD, et une borne de sortie 451OUT. La borne de référence 451GND est reliée, de préférence connectée à la borne de source 401S1 du transistor de puissance 401 et à la borne de source 471 du dispositif 400. La borne de sortie 451OUT est reliée, de préférence connectée à la borne de grille 401G du transistor de puissance 401. Des exemples détaillés de circuits de pilotage 451 sont décrits en relation avec les figures 22 à 24.
Les circuits logiques 452 (LOGIC) permettent de gérer toute la logique de commande du circuit de pilotage 451, ces circuits sont à la portée de la personne du métier. Selon un exemple, les circuits logiques mettent en oeuvre une porte logique de type "NON-ET" (NAND). Les circuits logiques 452 comprennent :

- une borne d'alimentation 452SUPP ;
- une borne d'entrée 452IN ;
- une borne de sortie 452OUT reliée, de préférence connectée, à la borne de commande 451CMD du circuit de pilotage 451 ;
- une borne de test de surchauffe 452OT ; et
- une borne de test de surintensité 452OC.

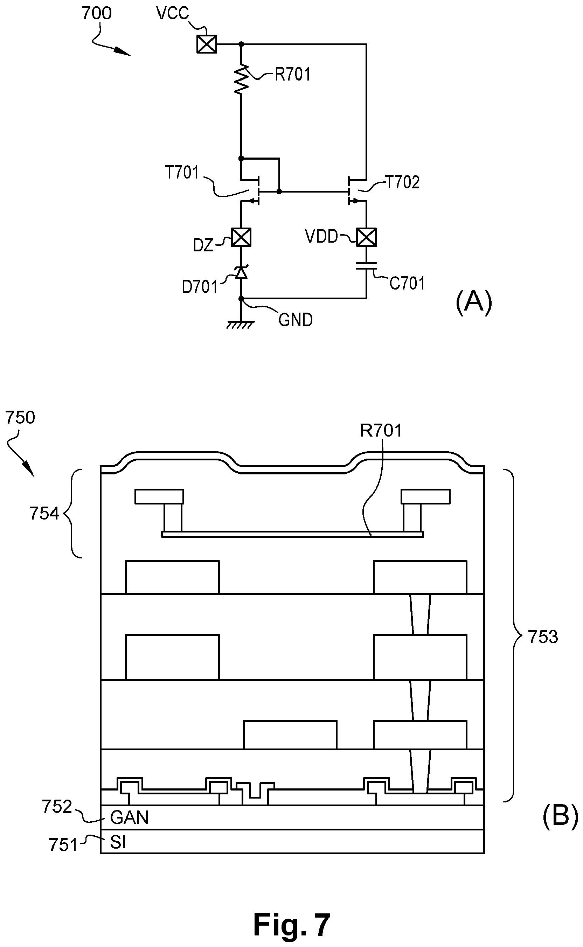

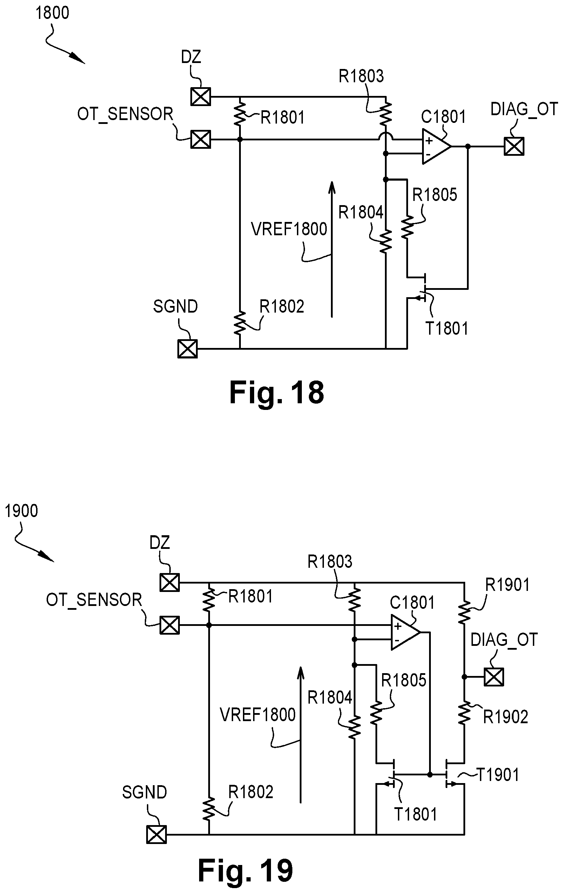

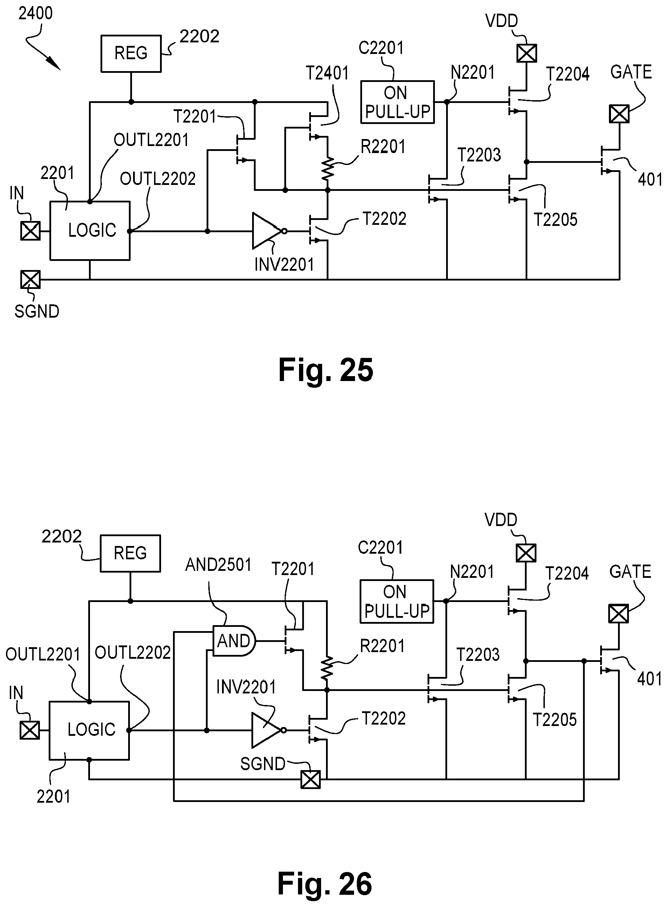

Les circuits logiques 452 peuvent faire partie du circuit de pilotage 451.
Les circuits régulateurs de tension 453 (REG) sont des circuits fournissant, à partir d'une tension d'alimentation provenant de la borne 478, une tension d'alimentation adaptée à alimenter le circuit de pilotage 451, les circuits logiques 452 et les circuits de test 454 et 455. Les circuits comprennent une borne d'entrée 453, une borne de commande 453CMD, et au moins deux bornes d'alimentation de sortie 453OUT1 et 453OUT2. La borne d'entrée 453IN est reliée, de préférence connectée, à la borne d'alimentation 478 du dispositif 400. La borne de commande 453CMD est reliée, de préférence connectée, à la borne de commande 477 du dispositif 400. La borne d'entrée 453OUT1 fournit, par exemple, une tension d'alimentation aux circuits 452, 454 et 455, et est, entre autres, reliée de préférence connectée, à la borne 452SUPP des circuits logiques 452. La borne d'entrée 453OUT2 fournit, par exemple, une tension d'alimentation au circuit de pilotage 451, et est reliée, de préférence connectée, à la borne 451SUPP du circuit de pilotage 451, et à la borne d'alimentation 476 du dispositif 400. Des exemples détaillés de circuits régulateurs de tensions 453 sont décrits en relation avec les figures 7 à 17.
Le circuit de protection contre les surchauffes 454 (OT Prot) permet de détecter une augmentation anormale de la température, par exemple un dépassement d'une température seuil, par exemple de l'ordre de 175 °C, pouvant endommager le dispositif 400. Le circuit 454 comprend une borne d'alimentation 454SUPP et une borne de sortie 454OUT. La borne d'alimentation 454SUPP est reliée, de préférence connectée, à la borne de sortie 453OUT1 des circuits 453. La borne de sortie 454OUT est reliée, de préférence connectée, à la borne de test 474 du dispositif 400 et à la borne de test 452OT des circuits logiques 452. Des exemples détaillés de circuits de protection contre les surchauffes 454 sont décrits en relation avec les figures 18 à 21.
Le circuit de protection contre les surintensités 455 (OC Prot), ou circuit de protection contre les pics de courant, permet de détecter une augmentation anormale du courant pouvant endommager le dispositif 400. Le circuit 455 comprend une borne d'alimentation 455SUPP, une borne de test 455LOGIC des circuits logiques, et une borne de test 455T du transistor de puissance 401. La borne d'alimentation 455SUPP est reliée, de préférence connectée, à la borne de sortie 453OUT1 des circuits 453. La borne de test 454LOGIC est reliée, de préférence connectée, à la borne de test 473 du dispositif 400 et à la borne de test 452OC des circuits logiques 452. La borne de test 455T est reliée, de préférence connectée, à la borne de source 401S2 du transistor de puissance 401. Des exemples détaillés de circuits de protection contre les surintensités 454 sont décrits en relation avec les figures 26 à 28.

La résistance 456 est disposée entre les bornes de sources 401S1 et 401S2 du transistor de puissance 401. Plus particulièrement, une première borne de la résistance 456 est reliée, de préférence connectée, à la borne de source 401S1, et une deuxième borne de la résistance 456 est reliée, de préférence connectée, à la borne de source 401S2 et à la borne de test 455T du circuit 455. La résistance 456 est une résistance shunt permettant de lire la tension entre la drain et la source du transistor 401 quand celui-ci est conducteur ou passant.

Le ou plusieurs circuits de protection contre les décharges électrostatiques 457 (ESD) permettent de protéger tout ou partie des bornes de connexions d'entrée et de sortie 470 à 478 du dispositif 400. En figure 4, les bornes 473 à 478 sont chacune protégées par un circuit 457. Plus particulièrement, six circuits 457 sont placés, respectivement, entre les bornes 478 et 453IN, les bornes 477 et 453CMD, les bornes 476 et 453OUT2, les bornes 475 et 452IN, les bornes 474 et 454OUT, et les bornes 473 et 455LOGIC.

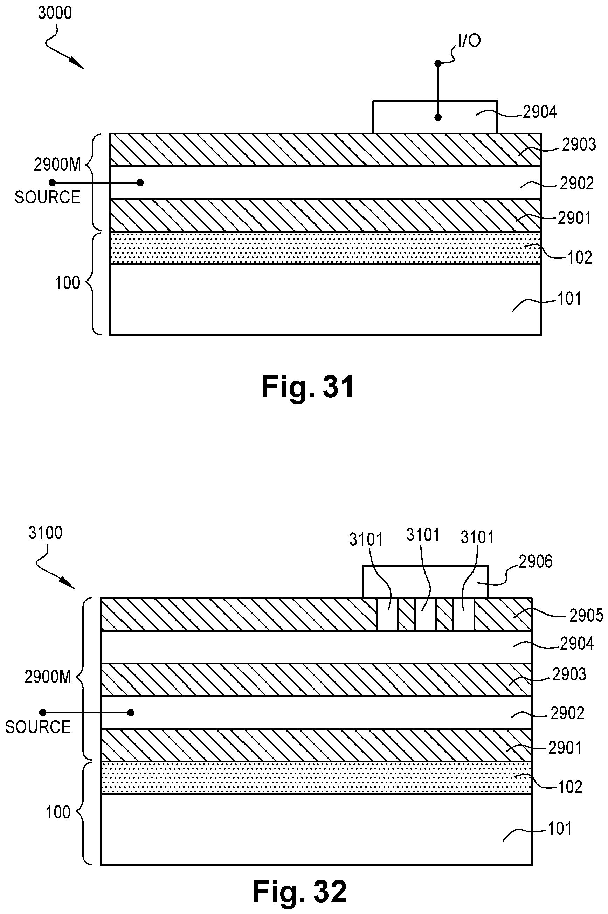

Les dispositifs 400 peut avoir être utilisés dans plusieurs types de systèmes électroniques, par exemple des circuits intégrés, comme des alimentation à découpage, des convertisseurs boost (boost converter). Un vue de dessus d'un exemple de réalisation du dispositif 400 est décrit en relation avec la figure 6. Des exemples détaillés d'application du dispositif 400 sont décrits en relation avec les figures 32 à 34.

La figure 5 est une vue de dessus schématique d'un ou d'une partie d'un assemblage 500 permettant de former un transistor de puissance du type du transistor 401 décrit en relation avec la figure 4.

L'assemblage 500 est formé par plusieurs transistors e-mode ou normalement OFF disposés en parallèle et ayant une région de drain commune 501, une région de source commune 502 et une région de grille commune 503. Pour cela, les régions 501, 502 et 503 ont chacune une forme de peigne et sont emboîtées les unes dans les autres comme illustré en figure 5.

Le région de drain 501 est reliée, de préférence connectée, à un noeud de drain 500D. Le région de source 502 est reliée, de préférence connectée, à un noeud de source 500S. Le région de grille 503 est reliée, de préférence connectée, à un noeud de grille 500G.

Seule une portion d'un assemblage 500 est représentée en figure 5. Les régions 501 à 503 peuvent comprendre chacune jusqu'à 28 "dents", c'est-à-dire portions horizontales en figure 5. Pour former le transistor 401 de la figure 1 plusieurs assemblage 500 peuvent être reliés, voire connectés, entre eux.

La figure 6 est une vue de dessus d'un exemple pratique de réalisation du dispositif 400 décrit en relation avec la figure 4. Comme décrit précédemment le dispositif 400 est formé dans et sur une structure comprenant du Nitrure de Gallium.

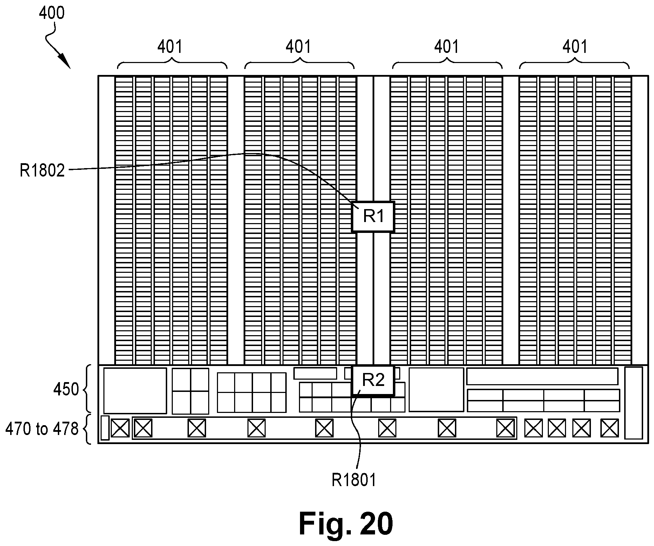

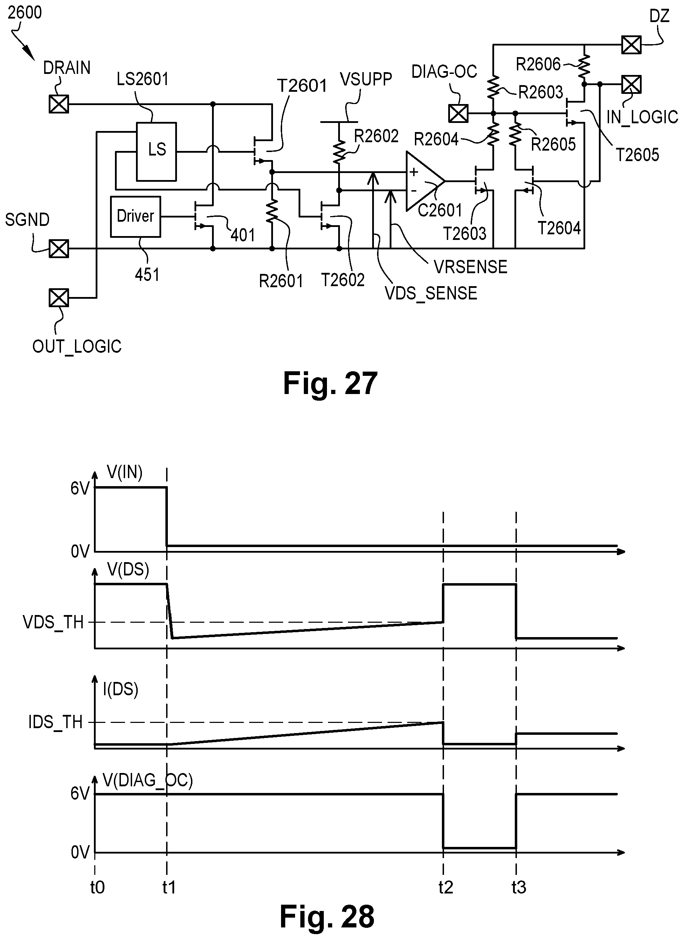

En figure 6, le transistor 401 est formée par au moins quatre assemblages du type de l'assemblage 500 décrit en relation avec la figure 5. Les assemblages sont séparés verticalement par des régions pouvant comprendre, certains exemples sont décrits en relation avec les figures 20 et 28, des circuits du circuit analogique de commande 450. Le reste du circuit analogique de commande 450 est formé contre le transistor 401. Les bornes de connexion d'entrée/sortie 470 à 478 (référencées 470 to 478 en figure 6) sont formés en périphérie de la structure dans et sur laquelle est formé le dispositif 400.

Les figures 7 à 17 représentent schématiquement, et partiellement sous forme de blocs, des exemples de réalisation de circuits régulateurs de tension pouvant faire partie des circuits régulateurs de tension 453 décrits en relation avec la figure 4.

La figure 7 comprend deux vues (A) et (B). La vue (A) représente un premier mode de réalisation d'un circuit régulateur de tension 700, adapté à faire partie du dispositif 400 décrit en relation avec la figure 4. La vue (B) est une vue en coupe d'une structure formant une partie du circuit 700.

Le circuit régulateur de tension 700 est adapté à être relié à trois bornes de connexion du dispositif 400, et plus particulièrement :

- à une borne VCC correspondant à la borne de connexion 478 du dispositif 400 ;
- à une borne DZ correspondant à la borne de connexion 477 du dispositif 400 ; et
- à une borne VDD correspondant à la borne de connexion 476 du dispositif 400.

Le circuit 700 comprend entre la borne VCC et la borne DZ une résistance R701 et un transistor T701 de type e-mode. Plus particulièrement, une première borne de la résistance R701 est reliée, de préférence connectée, à la borne VCC, et une deuxième borne de la résistance R701 est reliée, de préférence connectée, au drain du transistor T701. La source du transistor T701 est reliée, de préférence connectée, à la borne DZ. De plus, la grille du transistor T701 est reliée, de préférence connectée, au drain du transistor T701. La résistance R701 est une résistance de polarisation, formé dans une structure à deux dimensions (2DEGAN) comprenant du Nitrure de Gallium, et ayant un coefficient de température positif.

Le circuit 700 comprend, en outre, un transistor T702 de type e-mode disposé entre les bornes VCC et VDD.

Plus particulièrement, le drain du transistor T702 est reliée, de préférence connectée, à la borne T702, et la source du transistor T702 est reliée, de préférence connectée à la borne VDD. De plus, la grille du transistor T702 est reliée, de préférence connectée, à la grille du transistor T701. Le transistor T701 permet de compenser la tension de seuil Vth(T702) du transistor T702. Le courant I(T701) traversant le transistor T701 est donnée par la formule mathématique suivante :

[Math 1]

$$I(T701) = \frac{V(VCC) - Vth(T701) - V(DZ)}{R701}$$

dans laquelle

- V(VCC) représente la tension au niveau de la borne VCC ;
- V(DZ) représente la tension au niveau de la borne DZ ;
- Vth(T701) est la tension de seuil du transistor T701 ; et
- R701 correspond à la résistance de la résistance R701.

Le circuit 700 comprend, en outre, une diode Zener D701 entre la borne DZ et un noeud de référence GND, recevant par exemple la masse. La cathode de la diode D701 est reliée, de préférence connectée, à la borne DZ, et son anode est reliée, de préférence connectée, au noeud GND. La diode Zener est externe au dispositif 400, ou est formée sur une portion de la structure 100 de la figure 1 dans laquelle le substrat n'est pas recouverte de la couche de Nitrure de Gallium.

Le circuit 700 comprend, en outre et de façon optionnelle, un condensateur C701 ayant une fonction de condensateur tampon. Le condensateur C701 est disposé entre la borne VDD et le noeud de référence GND. Une première borne du condensateur C701 est reliée, de préférence connectée, à la borne VDD, et une deuxième borne du condensateur C701 est reliée, de préférence connectée, au noeud GND. Selon un exemple, le condensateur C701 est externe au dispositif 400, ou est formée sur une portion de la structure 100 de la figure 1 dans laquelle le substrat n'est pas recouverte de la couche de Nitrure de Gallium.

Selon un mode de réalisation, la résistance R701 peut être formée directement dans la couche de Nitrure de Gallium de la structure du dispositif 400, et peut comprendre une coefficient de température positif. Selon une variante, la résistance R701 peut être une résistance en un alliage de Silicium et de Chrome (SiCr). Sur la vue (B) de la figure 7, le placement de la résistance R701 est représenté. Plus particulièrement, en vue (B), une vue en coupe d'une structure 750 du type de la structure 100 décrite en relation avec la figure 1 est représentée. La structure 750 comprend, successivement :

- un substrat semiconducteur 751 (Si), par exemple en silicium ;
- une couche en Nitrure de Gallium 752 (GAN) ; et
- des niveaux de métallisations 753.

Dans le dernier niveau de métallisation 754 des niveaux 753, c'est-à-dire le niveau plus éloigné de la couche de Nitrure de Gallium 752, la structure 750 comprend des métallisations à partir de laquelle la résistance R701 peut être formée.

Le circuit 700 permet de fournir un courant au niveau de la borne DZ, et de créer une tension aux bornes de la diode Zener D701. Cette tension est indépendante de la tension fournie au niveau de la borne VCC et peut être utilisée pour alimenter un ou plusieurs circuits du circuit de commande 450 du dispositif 400 par l'intermédiaire de la borne VDD. De plus, cette tension peut servir de tension de référence stable permettant de créer la tension d'alimentation fournie au niveau de la borne VDD.

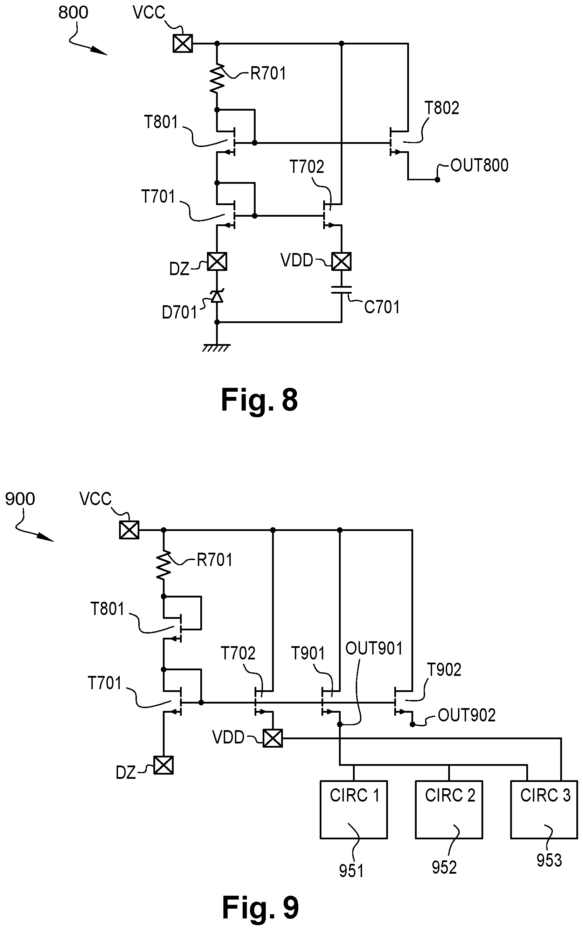

La figure 8 représente un deuxième mode de réalisation d'un circuit régulateur de tension 800, adapté à faire partie du dispositif 400 décrit en relation avec la figure 4.

Le circuit 800 présente des éléments communs avec le circuit 700 de la figure 7. Ces éléments ne seront pas décrits de nouveau et seules les différences entre les circuits 700 et 800 seront mises en exergue.

Le circuit 800 comprend les mêmes bornes que le circuit 700 et tous les composants du circuit 700, mais comprend, en outre, deux transistors de type e-mode T801 et T802.

Le transistor T801 est placé entre la résistance R701 et le transistor T701. Le drain du transistor T801 est relié, de préférence connecté, à la borne de la résistance R801 qui n'est pas reliée à la borne VCC, et la source du transistor T801 est reliée, de préférence connectée au drain du transistor T701. De plus, la grille du transistor T801 est reliée, de préférence connectée, au drain du transistor T801. Le transistor T801 est un transistor suiveur de tension.

Le transistor T802 est placé entre la borne VCC et un noeud de sortie OUT800 du circuit 800. Le drain du transistor T802 est relié, de préférence connecté, à la borne VCC, et la source du transistor T801 est reliée, de préférence connectée au noeud OUT800. De plus, la grille du transistor T802 est reliée, de préférence connectée, à la grille du transistor T801.

Le courant I(DZ) fourni au niveau de la borne DZ est donné par la formule mathématique suivante :

[Math 2]

$$I(DZ) = \frac{V(VCC) - Vth(T701) - Vth(T801) - V(DZ)}{R701}$$

dans laquelle Vth(T801) est la tension de seuil du transistor T801.

La tension V(VDD) fournie au niveau de la borne VDD est donnée par la formule mathématique suivante :

[Math 3]    $$V(VDD) = V(DZ) + Vth(T701) + Vth(T702)$$

dans laquelle Vth(T702) est la tension de seuil du transistor T702.

Comme le circuit 700, le circuit 800 fournit sur la borne VDD une tension d'alimentation, mais le circuit 800 peut fournir, en plus, au niveau du noeud OUT800 une deuxième tension d'alimentation indépendante de la tension reçue sur le noeud VCC et de la tension fournie au niveau du noeud VDD. Si une deuxième tension d'alimentation n'est pas nécessaire le transistor T802 peut être omis. L'avantage de fournir plusieurs tensions d'alimentation indépendante est de permettre d'isoler une alimentation sur laquelle du bruit peut apparaître d'une alimentation plus sensible.

La figure 9 représente un troisième mode de réalisation d'un circuit régulateur de tension 900, adapté à faire partie du dispositif 400 décrit en relation avec la figure 4.

Le circuit 900 présente des éléments communs avec le circuit 700 de la figure 7 et le circuit 800 de la figure 8. Ces éléments ne seront pas décrits de nouveau et seules les différences entre les circuits 700, 800 et 900 seront mises en exergue.

Le circuit 900 comprend les mêmes bornes que le circuit 700 et tous les composants du circuit 700, mais peut comprendre, de façon optionnelle, le transistor T801 du circuit 800. Le circuit comprend, en outre au moins un transistor T901, et par exemple, un transistor T902 permettant de fournir plusieurs tensions d'alimentation en parallèle.

Le transistor T901 est placé entre la borne VCC et un noeud de sortie T901. Le drain du transistor T901 est relié, de préférence connecté, à la borne VCC, et la source du transistor T901 est reliée, de préférence connectée au noeud OUT901. De plus, la grille du transistor T901 est reliée, de préférence connectée, à la grille du transistor T701.

Le transistor T902 est placé entre la borne VCC et un noeud de sortie T902. Le drain du transistor T902 est relié, de préférence connecté, à la borne VCC, et la source du transistor T902 est reliée, de préférence connectée au noeud OUT902. De plus, la grille du transistor T902 est reliée, de préférence connectée, à la grille du transistor T701.

Les noeuds OUT901 et OUT902 et la borne VDD fournissent chacun une tension d'alimentation. Ces tensions d'alimentation peuvent être utilisée pour alimenter différents circuits du circuit de commande 450 du dispositif 400. En particulier, en figure 9, trois circuits 951 (CIRC 1), 952 (CIRC 2) et 953 (CIRC 3) pouvant faire partie du circuit 450 sont représentés et sont alimentés par la tension d'alimentation fournie par le noeud OUT901. De plus, le circuit 953 est, en outre, alimenté par la tension fournie par la borne VDD. Selon un exemple, les circuits 951, 952 et 953 peuvent être choisies parmi le groupe comprenant : les circuits de protections 473, 474 et 453, les circuits logiques 452 et le circuit de pilotage 451. Comme dit précédemment, l'avantage de fournir plusieurs tensions d'alimentation indépendante est de permettre d'isoler une alimentation sur laquelle du bruit peut apparaître d'une alimentation plus sensible.

Selon une variante, le circuit 900 pourrait comprendre d'autres transistors disposés de façon similaire aux transistors T901 et T902 pour fournir d'autres tensions d'alimentation sur d'autres noeuds de sortie du circuit 900.

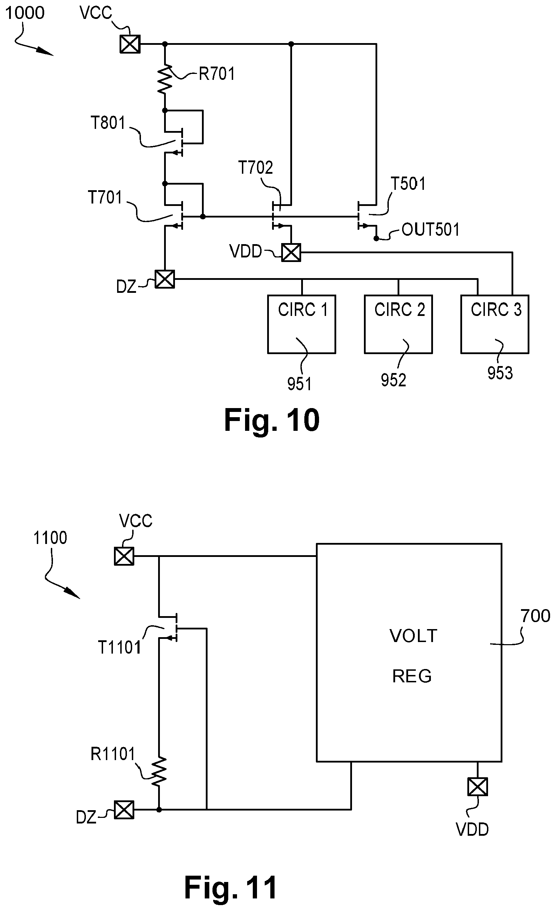

La figure 10 représente un quatrième mode de réalisation d'un circuit régulateur de tension 1000, adapté à faire partie du dispositif 400 décrit en relation avec la figure 4.

Le circuit 1000 présente des éléments communs avec le circuit 700 de la figure 7, le circuit 800 de la figure 8, et le circuit 900 de la figure 9. Ces éléments ne seront pas décrits de nouveau et seules les différences entre les circuits 700, 800, 900 et 1000 seront mises en exergue.

Le circuit 1000 est similaire au circuit 900 mais ne comprend pas de transistor T902 et de noeud de sortie OUT902.

La différence importante entre le circuit 1000 et le circuit 900 est que la tension au niveau de la borne DZ est utilisée pour alimenter les circuits 951, 952 et 953.

De plus, un avantage de ce mode de réalisation est que l'alimentation fournie au niveau de la borne DZ est plus précise que celle fournie par les transistors T702, T901 et T902.

La figure 11 représente un cinquième mode de réalisation d'un circuit régulateur de tension 1100, adapté à faire partie du dispositif 400 décrit en relation avec la figure 4.

Le circuit régulateur de tension 1100 est adapté à être relié à trois bornes de connexion du dispositif 400, et plus particulièrement :

- à la borne VCC correspondant à la borne de connexion 478 du dispositif 400 ;
- à la borne DZ correspondant à la borne de connexion 477 du dispositif 400 ; et
- à la borne VDD correspondant à la borne de connexion 476 du dispositif 400.

Le circuit régulateur de tension 1100 comprend un circuit régulateur de tension, et plus particulièrement, en figure 11, le circuit régulateur de tension 700 (VOLT GEN) décrit en relation avec la figure 7. Selon une variante, le circuit régulateur de tension pourrait être le circuit 800 décrit en relation avec la figure 8, le circuit 900 décrit en relation avec la figure 9, ou le circuit 1000 décrit en relation avec la figure 10.

Le circuit 1100 comprend, en outre, un transistor de type d-mode T1101 et une résistance R1101. Le transistor T1101 et la résistance R1101 sont disposés entre les bornes VCC et DZ. Plus particulièrement, le drain du transistor T1101 est reliée, de préférence connectée, à la borne VCC, et la source du transistor T1101 est reliée, de préférence connectée, à une première borne de la résistance R1101. La grille du transistor T1101 est reliée, de préférence connectée à la borne DZ. La deuxième borne de la résistance R1101 est reliée, de préférence connectée, à la borne DZ.

La résistance R1101 est du même type que la résistance R701 du circuit 700 e la figure 7.

Le courant de sortie du circuit 100 est délivré au niveau de la borne DZ et est proportionnel à la tension entre la grille du transistor T1101 et de la résistance R1101. Le courant de sortie I(DZ) est donnée par la formule mathématique suivante :

[Math 4]

$$I(DZ) = -\frac{Vth(T1101)}{R1101}$$

dans laquelle :

- Vth(T1101) est la tension de seuil du transistor T1101 ; et
- R1101 est la résistance de la résistance R1101.

De plus, le régulateur de tension 1100 décrit en relation avec la figure 11 diffère des régulateurs de tension 700 à 1000 décrits en relation avec les figures 7 à 10 en ce qu'il permet de fournir une tension de sortie au niveau du noeud VDD, mais aussi un courant de sortie au niveau de la borne DZ. Ce courant de sortie a la particularité de ne pas dépendre des variations de tension et de courant pouvant subvenir au niveau de la borne VCC, contrairement à un courant fourni au niveau de la borne DZ par un des régulateurs de tension 700 à 1000 qui est dépendant de la tension VCC.

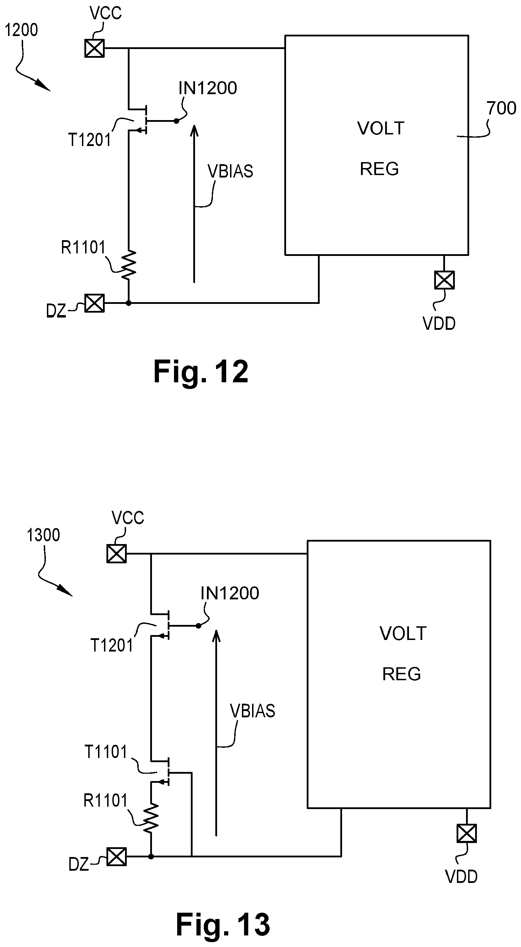

La figure 12 représente un sixième mode de réalisation d'un circuit régulateur de tension 1200, adapté à faire partie du dispositif 400 décrit en relation avec la figure 4.

Le circuit 1200 présente des éléments communs avec le circuit 1100 de la figure 11. Ces éléments ne seront pas décrits de nouveau et seules les différences entre les circuits 1100 et 1200 seront mises en exergue.

Le circuit 1200 comprend les mêmes bornes que le circuit 1100, la résistance R1101 et le circuit 700 (VOLT GEN), mais comprend, à la place du transistor T1101 un transistor T1201.

Le transistor T1201 est un transistor de type e-mode, ou normalement OFF. Le drain du transistor T1201 est reliée, de préférence connectée, à la borne VCC, et la source du transistor T1201 est reliée, de préférence connectée, à une première borne de la résistance R1101. La deuxième borne de la résistance R1101 est reliée, de préférence connectée, à la borne DZ. La grille du transistor T1201 est reliée, de préférence connectée, à un noeud d'entrée IN1200 reçoit une tension de polarisation VBIAS permettant de rendre le transistor T1201 passant. Selon une variante de réalisation, le transistor T1201 est un transistor de type d-mode.

Comme le circuit 1100, le circuit 1200 fournit sur le noeud DZ un courant de sortie proportionnel à la résistance de la résistance R1101, et indépendant des variations de courant et de tension présents au niveau de la borne VCC.

L'avantage de ce mode de réalisation est de choisir un transistor T1201 dimensionné pour des tensions plus élevées, par exemple des tensions comprises entre 10 et 30 V. Cela permet donc d'appliquer au niveau de la borne VCC une tension comprise entre 10 et 30 V.

La figure 13 représente un septième mode de réalisation d'un circuit régulateur de tension 1300, adapté à faire partie du dispositif 400 décrit en relation avec la figure 4.

Le circuit 1300 présente des éléments communs avec le circuit 1100 de la figure 11 et avec le circuit 1200 de la figure 11. Ces éléments ne seront pas décrits de nouveau et seules les différences entre les circuits 1100, 1200, et 1300 seront mises en exergue.

Le circuit 1300 est un combinaison des circuits 1100 et 1200. En pratique le circuit 1300 comprend les transistors T1101 et T1201 et la résistance R1101 et le circuit 700.

Plus particulièrement, le transistor T1201 est positionné du côté de la borne VCC et le transistor T1101 est positionné du côté de la résistance R1101. Selon un exemple, dans cette configuration, le transistor T1201 a pour fonction d'isoler la tension reçue par la borne VCC du drain du transistor T1101.

Un mode de réalisation préféré est le circuit 1300 comprenant le circuit régulateur de tension 1000.

Comme les circuits 1100 et 1200, le circuit 1300 a l'avantage de fournir un courant de sortie indépendant des variations de courant et de tension présents au niveau de la borne VCC.

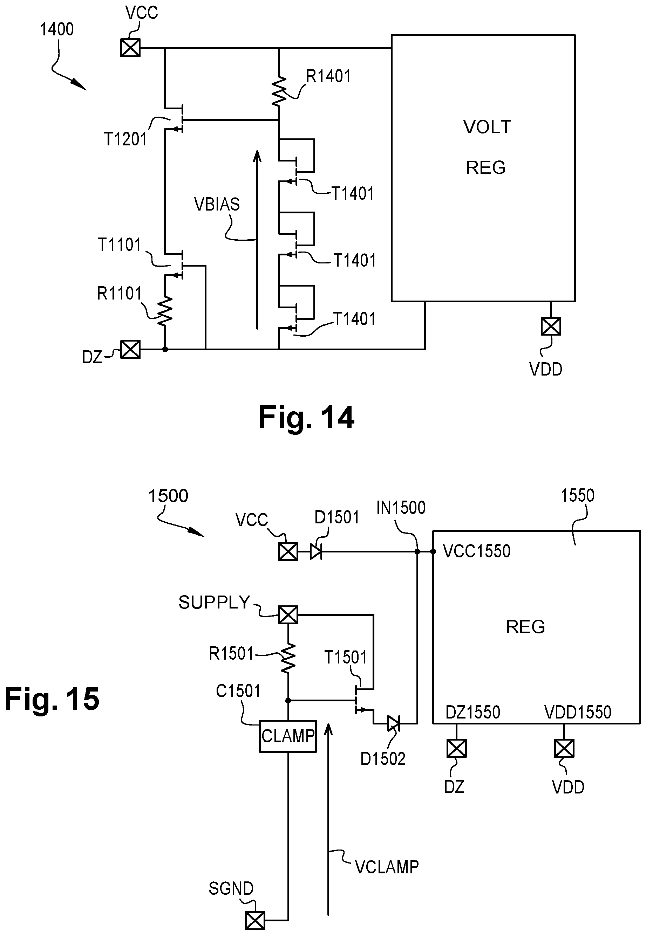

La figure 14 représente un huitième mode de réalisation d'un circuit régulateur de tension 1400, adapté à faire partie du dispositif 400 décrit en relation avec la figure 4.

Le circuit 1400 présente des éléments communs avec les circuits 1100, 1200 et 1300 des figures 11 à 13. Ces éléments ne seront pas décrits de nouveau et seules les différences entre les circuits 1100, 1200, 1300 et 1400 seront mises en exergue.

Le circuit 1400 comprend tous les composants du circuit 1300 mais comprend en outre une nouvelle branche entre les bornes VCC et DC permettant d'appliquer la tension VBIAS à la grille du transistor T1201.

Cette nouvelle branche comprend une résistance R1401 et plusieurs transistors T1401 de type e-mode disposés en série. En figure 14, le circuit 1400 comprend trois transistors T1401. Une première borne de la résistance R1401 est reliée, de préférence connectée, à la borne VCC, et la deuxième borne de la résistance R1401 est reliée, de préférence connectée, à la grille du transistor T1201 et au drain d'un premier transistor T1401. La source du premier transistor T1401 est reliée, de préférence connectée, au drain du transistor T1401 suivant, et ainsi de suite. La source du dernier transistor T1401 est reliée, de préférence connectée, à la borne DZ. De plus, chaque transistor T1401 a sa grille reliée, de préférence connectée, à son drain, et est ainsi connecté en "diode".

La résistance R1401 et les transistors T1401 sont dimensionnés pour fournir la tension VBIAS à la grille du transistor T1201. De plus, la résistance R1401 est une résistance de polarisation, qui permet de limiter le courant traversant le transistor T1401. La tension VBIAS est donnée par la formule mathématique suivante :

[Math 5]

$$VBIAS = 3 * Vth(T1401)$$

dans laquelle Vth(T1401) est la tension de seuil d'un des transistors T1401.

Le courant I(R1401) traversant la résistance R1401 est donné par la formule mathématique suivante :

[Math 6]

$$VI(R1401) = \frac{V(VCC) - 3 * Vth(T1401) - V(DZ)}{R1041}$$

dans laquelle R1401 est la résistance de la résistance R1401.

Comme les circuits 1100, 1200 et 1300, le circuit 1400 a l'avantage de fournir un courant de sortie indépendant des variations de courant et de tension présents au niveau de la borne VCC.

La figure 15 représente un premier mode de réalisation d'un circuit de régulation de haute tension 1500, ou circuit régulateur de haute tension 1500, adapté à faire partie du dispositif 400 décrit en relation avec la figure 4.

Le circuit de régulation de haute tension 1500 est adapté à être relié à cinq bornes de connexion du dispositif 400, et plus particulièrement :

- à la borne VCC correspondant à la borne de connexion 478 du dispositif 400 ;
- à la borne DZ correspondant à la borne de connexion 477 du dispositif 400 ;
- à la borne VDD correspondant à la borne de connexion 476 du dispositif 400 ;
- à une borne SUPPLY interne du dispositif 400 adapté à recevoir une tension maximale de l'ordre de 400 V ; et
- à une borne SGND correspondant à la borne de connexion 472 de référence du dispositif 400.

Le circuit de régulation de haute tension 1500 est un circuit adapté à recevoir une tension maximale de l'ordre de 400 V sur la borne SUPPLY, et à fournir une tension sur la borne VDD inférieure à la tension fournie à la borne DZ.

Le circuit de régulation 1500 comprend un circuit 1550 (GEN) pouvant être un circuit régulateur de tension comme l'un des circuits décrits en relation avec les figures 7 à 10 ou leurs variantes, ou pouvant être un circuit régulateur de tension comme l'un des circuits décrits en relation avec les figures 11 à 14 ou leurs variantes. Comme décrit en relation avec les figures 7 à 14, le circuit 1550 est adapté à être relié, de préférence connecté, à trois bornes du dispositif 400, en particulier les bornes VCC, DZ et VDD. Le circuit 1550 comprend alors une borne VCC1550 normalement reliée à la borne VCC, une borne DZ1550 normalement reliée à la borne DZ, et une borne VDD1550 normalement reliée à la borne VDD. Dans le circuit 1500, la borne VCC1550 est reliée, de préférence connectée, au noeud IN1500, la borne DZ1550 est reliée, de préférence connectée, à la borne DZ, et la borne VDD1550 est reliée, de préférence connectée, à la borne VDD.

Le circuit 1500 comprend, en outre, entre la borne VCC et le noeud IN1500, une diode D1501 de type HEMT, ou diode à haute mobilité d'électron. L'anode de la diode D1501 est reliée, de préférence connectée, à la borne VCC, et la cathode de la diode D1501 et reliée, de préférence connectée, au noeud IN1500.

Le circuit 1500 comprend, en outre, entre la borne SUPPLY et le noeud IN1500, un transistor T1501 de type e-mode et une diode D1502. Le drain du transistor T1501 est reliée, de préférence connectée, à la borne SUPPLY, et la source du transistor T1501 est reliée, de préférence connectée, à l'anode de la diode D1502. La cathode de la diode D1502 est reliée, de préférence connectée, au noeud IN1500.

Le circuit 1500 comprend, en outre, entre la borne SUPPLY et la borne SGND, une résistance R1501 et une bascule C1501 (CLAMP). Une première borne de la résistance R1501 est reliée, de préférence connectée, à la borne SUPPLY, et une deuxième borne de la résistance R1501 est reliée, de préférence connectée, à une première borne de la bascule C1501. La deuxième borne de la bascule C1510 est reliée, de préférence connectée, à la borne SGND.

Le fonctionnement du circuit 1500 est le suivant. Lorsque la tension entre la grille et la source du transistor T1501 est supérieure à la tension de seuil du transistor T1501 alors le transistor T1501 est conducteur, et le noeud IN1500 reçoit alors la tension provenant de la borne SUPPLY, car le transistor T1501 est un transistor suiveur de tension. A l'inverse, lorsque la tension entre la grille et la source du transistor T1501 est inférieure à la tension de seuil du transistor T1501 alors le transistor T1501 ne conduit plus, et le noeud IN1500 reçoit alors le courant provenant de la borne VCC.

Ainsi, lorsque la tension délivrée par la borne VCC dépasse la différence entre la tension aux bornes de la bascule C1501 et la tension de seuil du transistor T1501, alors l'alimentation du circuit 1550 est modifiée pour provenir de la borne VCC et non plus de la borne SUPPLY. Cela permet d'éviter une trop haute consommation d'énergie à partir de la borne SUPPLY. La bascule C1501 est dimensionnée pour que le transistor T1501 reste passant jusqu'à ce que la tension de la borne SUPPLY dépasse la tension seuil. La borne SUPPLY fournit tout de même une courant de l'ordre de 40 μA, correspondant au courant traversant la résistance R1501.

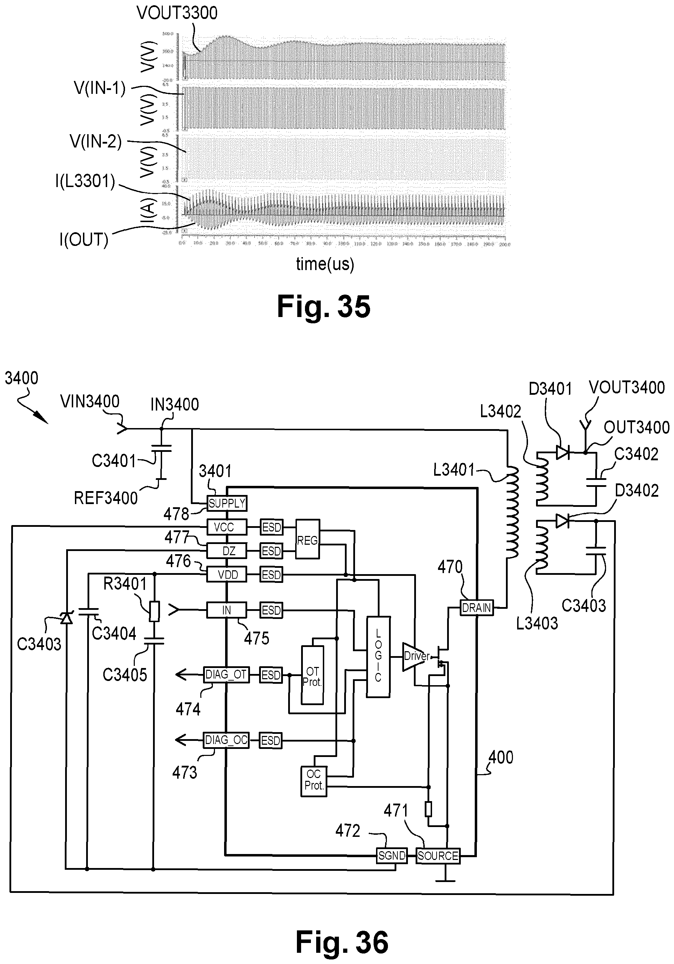

Ce mode de réalisation est utilisé dans le mode de réalisation décrit en relation avec la figure 36.

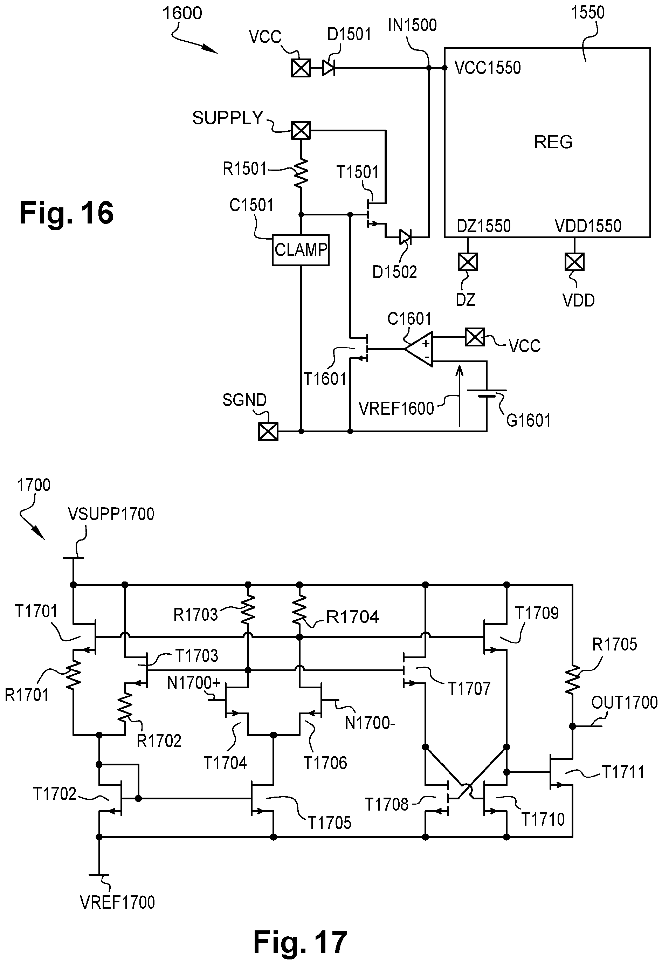

La figure 16 représente un deuxième mode de réalisation d'un circuit de régulation de haute tension 1600, ou circuit régulateur de haute tension 1600, adapté à faire partie du dispositif 400 décrit en relation avec la figure 4.

Le circuit 1600 présente des éléments communs avec le circuit 1500 de la figure 15. Ces éléments ne seront pas décrits de nouveau et seules les différences entre les circuits 1500 et 1600 seront mises en exergue.

Le circuit 1600 comprend tous les composants du circuit 1500 mais comprend, en outre, un circuit de commande du transistor T1501, disposé entre la grille du transistor T1501 et la borne SGND.

Le circuit de commande comprend un transistor T1601 de type e-mode, un comparateur C1601 et une source de tension G1601. Le drain du transistor T1601 est reliée, de préférence connectée, à la grille du transistor T1501, et la source du transistor T1501 est reliée, de préférence connectée, à la borne SGND. La grille du transistor C1601 reçoit une tension de sortie du comparateur C1601. Le comparateur reçoit, en entrée la tension de la borne VCC et une tension de référence VREF1600 fournit par la source de tension G1601. Un exemple de réalisation du comparateur C1601 est décrit en relation avec la figure 17.

Le fonctionnement du circuit 1600 est le suivant. Lorsque la tension de la borne VCC est inférieure à la tension de référence VREF1600, ce qui arrive au moment du démarrage du dispositif 400, un courant provenant de la borne SUPPLY est fourni par le transistor T1501, le transistor T1501 étant conducteur de par les dimensions de la résistance R1501. En effet, la résistance R1501 a une résistance plutôt élevée pour baisser la consommation en énergie du dispositif 400, par exemple une résistance de l'ordre de 10 MOhm. Le courant I(R1501) traversant la résistance R1501 est donné par la formule mathématique suivante :

[Math 7]

$$I(R1501) = \frac{V(SUPPLY) - V(CLAMP)}{R1501}$$

dans laquelle :

- V(SUPPLY) est la tension au niveau de la borne SUPPLY ;

- V(CLAMP) est la tension aux bornes de la bascule C1501 ; et

- R1501 est la résistance de la résistance R1501.

Lorsque la tension de la borne VCC est supérieure à la tension de référence VREF1600, c'est-à-dire au moment où les circuits d'alimentation du dispositif 400 ont démarré et sont capables de fournir une tension d'alimentation le transistor T1501 n'est plus conducteur, et le noeud IN1500 reçoit une tension de la part de la borne VCC.

La figure 17 représente un exemple de réalisation d'un circuit comparateur 1700 pouvant être utilisé comme comparateur C1601 dans le circuit 1600 de la figure 16.

Le circuit comparateur 1700 comprend deux noeuds d'alimentation VSUPP1700 et VREF1700, deux noeuds d'entrée N1700+ et N1700- et un noeud de sortie OUT1700. Le noeud d'alimentation VSUPP1700 reçoit une tension supérieure à la tension reçu par le noeud VREF1700, par exemple le noeud d'alimentation VSUPP reçoit une tension de l'ordre de 6 V et le noeud VREF1700 reçoit une tension de l'ordre de 0 V. Les noeuds d'entrée N1700+ et N1700- reçoivent les tensions à comparer. Le noeud OUT1700 fournit la tension représentant le résultat de la comparaison des tensions reçues par les noeuds N1700+ et N1700-.

Le circuit 1700 comprend, entre les noeuds VSUPP1700 et VREF1700, et sur une première branche, un transistor T1701 de type d-mode, une résistance R1701, et un transistor T1702 de type d-mode. Le drain du transistor T1701 est reliée, de préférence connectée, au noeud VSUPP1700, et la source du transistor T1701 est reliée, de préférence connectée, à une première borne de la résistance R1701. La deuxième borne de la résistance R1701 est reliée, de préférence connectée, au drain et à la grille du transistor T1702. La source du transistor T1702 est reliée, de préférence connectée, au noeud VREF1700.

Le circuit 1700 comprend, en outre, entre le noeud VSUPP1700 et le noeud milieu entre la résistance R1701 et le transistor T1702, et sur un deuxième branche, un transistor T1703 de type d-mode et une résistance R1702. Le drain du transistor T1703 est relié, de préférence connecté, au noeud VSUPP1700, et la source du transistor T1703 est reliée, de préférence connectée, à une première borne de la résistance R1702. La deuxième borne de la résistance R1702 est reliée, de préférence connectée, au noeud milieu entre la résistance R1701 et le transistor T1702. Selon une variante de réalisation, les transistors T1701 et T1702 peuvent être des transistors de type e-mode.

Le circuit 1700 comprend, entre les noeuds VSUPP1700 et VREF1700, et sur une troisième branche, un résistance R1703, un transistor T1704 de type d-mode, et un transistor T1705 de type d-mode. Une première borne de la résistance R1703 est reliée, de préférence connectée, au noeud VSUPP1700, et deuxième borne de la résistance R1703 est reliée, de préférence connectée, au drain du transistor T1704 et à la grille du transistor T1703. La source du transistor T1704 est reliée, de préférence connectée, au drain du transistor T1705. La source du transistor T1705 est reliée, de préférence connectée, au noeud VREF1700. La grille du transistor T1704 est reliée, de préférence connectée, au noeud N1700+.

Le circuit 1700 comprend, entre les noeuds VSUPP1700 et VREF1700, et sur une quatrième branche, un résistance R1704, un transistor T1706 de type d-mode, et le transistor T1705. Une première borne de la résistance R1704 est reliée, de préférence connectée, au noeud VSUPP1700, et deuxième borne de la résistance R1704 est reliée, de préférence connectée, au drain du transistor T1706 et à la grille du transistor T1701. La source du transistor T1706 est reliée, de préférence connectée, au drain du transistor T1705. La grille du transistor T1706 est reliée, de préférence connectée, au noeud N1700-.

Le circuit 1700 comprend, entre les noeuds VSUPP1700 et VREF1700, et sur une cinquième branche, un transistor T1707 de type e-mode, et un transistor T1708 de type e-mode. Le drain du transistor T1707 est relié, de préférence connecté, au noeud VSUPP1700, et la source du transistor T1707 est reliée, de préférence connectée, au drain du transistor T1708. La source du transistor T1708 est reliée, de préférence connectée, au noeud VREF1700. La grille du transistor T1707 est reliée, de préférence connectée, à la grille du transistor T1703.

Le circuit 1700 comprend, entre les noeuds VSUPP1700 et VREF1700, et sur une sixième branche, un transistor T1709 de type d-mode, et un transistor T1710 de type d-mode. Le drain du transistor T1709 est relié, de préférence connecté, au noeud VSUPP1700, et la source du transistor T1709 est reliée, de préférence connectée, au drain du transistor T1710. La source du transistor T1710 est reliée, de préférence connectée, au noeud VREF1700. La grille du transistor T1709 est reliée, de préférence connectée, à la grille du transistor T1701.

Selon un premier mode de réalisation, illustré en figure 17, la grille du transistor T1708 est reliée, de préférence connectée, au drain du transistor T1710, et la grille du transistor T1710 est reliée, de préférence connectée, au drain du transistor T1708.

Selon une deuxième mode de réalisation, non illustré en figure 17, les grilles des transistors T1708 et T1710 sont reliées, de préférence connectées, entre elles et au drain du transistor T1708.

Le circuit 1700 comprend, entre les noeuds VSUPP1700 et VREF1700, et sur une septième et dernière branche, une résistance R1705 et transistor T1711 de type d-mode. Une première borne de la résistance R1705 est reliée, de préférence connectée, au noeud VSUPP1700, et une deuxième borne de la résistance R1705 est reliée, de préférence connectée, au noeud de sortie OUT1700. Le drain du transistor T1711 est relié, de préférence connecté, au noeud OUT1700, et la source du transistor T1711 est reliée, de préférence connectée, au noeud VREF1700. La grille du transistor T1711 est reliée, de préférence connectée, au drain du transistor T1710.

Les transistors T1704 et T1705 sont des transistors d'entrée différentielles. Les résistances R1701 et R1702 sont des résistances de polarisation. Les transistors T1701, T1702, T1703 et T1705 sont des transistors de polarisation. Les transistors T1707 et T1709 sont des transistors suiveurs de tension. Les transistors T1708 et T1710 sont des comparateurs de courants. La septième branche est une branche de sortie.

Le circuit comparateur 1700 fonctionne de la façon suivante. Lorsque la tension de grille du transistor T1706 devient supérieure à la tension de grille du transistor T1704, alors la tension de grille du transistor T1709 devient inférieure à la tension de grille du transistor T1707, ce qui entraine que la tension de grille du transistor T1711 devient inférieure à la tension de seuil du transistor T1711. La tension de sortie VOUT1700 est alors reliée à la tension VSUPP1700.

Les figures 18 à 21 représentent schématiquement, et partiellement sous forme de blocs, des modes de réalisation de circuits pouvant être un circuit de protection contre les surchauffes 454 décrit en relation avec la figure 4.

La figure 18 est un schéma électrique d'un premier mode de réalisation d'un circuit de protection contre les surchauffe 1800 adapté à faire partie du dispositif 400.

Le circuit de régulation de protection contre les surchauffes 1800 est adapté à être relié à quatre bornes de connexion du dispositif 400, et plus particulièrement :

- à la borne DZ correspondant à la borne de connexion 477 du dispositif 400 fournissant une tension d'alimentation positive, par exemple de l'ordre de 6 V ;
- à une borne OT_SENSOR correspondant à une borne de connexion de test interne du dispositif 400, cette borne est optionnelle ;
- à la borne de référence SGND correspondant à la borne de connexion 472 de référence du dispositif 400 ; et
- à une borne de test DIAG_OT correspondant à la borne de connexion 474 du dispositif 400.

Le circuit 1800 comprend, entre les bornes DZ et SGND, et sur une première branche, deux résistances R1801 et R1802. Une première borne de la résistance R1801 est reliée, de préférence connectée, à la borne DZ, et une deuxième borne de la résistance R1801 est reliée, de préférence connectée, à la borne OT_SENSOR. Une première borne de la résistance R1802 est reliée, de préférence connectée, à la borne OT_SENSOR, et une deuxième borne de la résistance R1802 est reliée, de préférence connectée, à la borne SGND. Selon une variante de réalisation, la borne DZ peut être remplacée par la borne VDD.

Selon un mode de réalisation, les résistances R1801 et R1802 ont des coefficients de température différents. La résistance R1802 a un coefficient de température positif et est positionnée dans une zone active du dispositif comprenant le circuit de protection 1800, par exemple au niveau du transistor de puissance 401. Ceci sera décrit plus en détails en relation avec la figure 20.

Selon un premier mode de réalisation, la résistance R1801 a un coefficient de température nul. La résistance R1801 peut être une résistance en un alliage de Silicium et de Chrome. Dans ce cas, la résistance R1801 n'est pas formée au même niveau que la résistance T1802. En particulier, la résistance R1802 peut être formée dans les niveaux de métallisations de la structure dans et sur laquelle est formé le dispositif 400, au niveau du circuit de commande 450, comme cela est décrit en relation avec la vue (B) de la figure 7. Ce mode de réalisation est décrit plus en détail en relation avec le figure 20.

Selon un deuxième mode de réalisation, la résistance R1801 peut avoir un coefficient de température positif ou négatif, mais toujours différent du coefficient de température de la résistance R1801. Dans ce cas la résistance R1801 peut être positionnée proche de la résistance R1802 dans le dispositif 400.

Le circuit 1800 comprend, entre les bornes DZ et SGND, et sur une deuxième branche, deux résistances R1803 et R1804. Une première borne de la résistance R1803 est reliée, de préférence connectée, à la borne DZ, et une deuxième borne de la résistance R1803 est reliée, de préférence connectée, à une première borne de la résistance R1804. Une deuxième borne de la résistance R1804 est reliée, de préférence connectée, à la borne SGND. Selon un

EP 4 358 406 A2

mode de réalisation, les résistances R1803 et R1804 sont du même type que la résistance R1801.

Le circuit 1800 comprend, en outre, un circuit comparateur C1801, du type du circuit comparateur 1700 décrit en relation avec la figure 17. Le circuit comparateur C1801 comprend une première borne (+) d'entrée reliée, de préférence connectée, à la borne OT_SENSOR, et une deuxième borne d'entrée (-) reliée, de préférence connectée, au noeud milieu entre les résistances R1803 et R1804. Le circuit comparateur C1801 comprend une sortie reliée, de préférence connectée, à la borne DIAG_OT. Le circuit comparateur C1801 comprend, en outre, de bornes d'alimentation non représentées.

Le circuit 1800 comprend, entre le noeud milieu entre les résistances R1803 et R1804, et la borne SGND, et sur une troisième branche, une résistance R1805 et un transistor T1801 de type e-mode. Une première borne de la résistance R1805 est reliée, de préférence connectée, au noeud milieu entre les résistances R1803 et R1804, et une deuxième borne de la résistance R1805 est reliée, de préférence connectée, au drain du transistor T1801. La source du transistor T1801 est reliée, de préférence connectée, à la borne SGND. La grille du transistor T1801 est reliée, de préférence connectée, à la sortie du circuit comparateur C1801.

Le fonctionnement du circuit 1800 est le suivant. Lorsque la température au niveau de la résistance R1802 augmente, la tension aux bornes de la résistance R1802 augmente et la tension aux bornes de la résistance R1801 ne change pas. La tension entre les bornes OT_SENSOR et SGND augmente alors, et si elle dépasse une tension de référence VREF1800, la tension de sortie du circuit comparateur C1801 augmente, ce qui entraîne la baisse de la tension de sortie, c'est-à-dire la tension entre les bornes DIAG_OT et SGND. La tension de référence VREF1800 est obtenue par le pont diviseur de tension formé par les résistances R1803 et R1804, et par l'hystérésis formé par le transistor T1801 et la résistance R1805.

La figure 19 représente un deuxième mode de réalisation d'un circuit protection contre les surchauffes 1900, adapté à faire partie du dispositif 400 décrit en relation avec la figure 4.

Le circuit 1900 présente des éléments communs avec le circuit 1800 de la figure 18. Ces éléments ne seront pas décrits de nouveau et seules les différences entre les circuits 1800 et 1900 seront mises en exergue.

Le circuit 1900 comprend tous les composants du circuit 1800 mais comprend en outre une quatrième branche de composants entre les bornes DZ et SGND. De plus, dans le circuit 1900 la sortie du circuit comparateur C1801 est reliée, de préférence connectée, seulement à la grille du transistor T1801 et non plus à la borne DIAG_OT.

Ladite quatrième branche comprend deux résistances R1901 et R1902, et un transistor T1901 de type e-mode. Une première borne de la résistance R1901 est reliée, de préférence connectée, à la borne DZ, et une deuxième borne de la résistance R1901 est reliée, de préférence connectée, à la borne DIAG_OT. Une première borne de la résistance R1902 est reliée, de préférence connectée, à la borne DIAG_OT, et une deuxième borne de la résistance R1902 est reliée, de préférence connectée, au drain du transistor T1901. Les résistances R1901 et R1902 ont des coefficients de température positifs toutes les deux. La source du transistor T1901 est reliée, de préférence connectée, à la borne SGND. La grille du transistor T1901 est reliée, de préférence connectée à la grille du transistor T1801 et à la sortie du circuit comparateur C1801.

Le fonctionnement du circuit 1900 est le suivant. Lorsque la température au niveau de la résistance R1802 augmente, la tension aux bornes de la résistance R1802 augmente et la tension aux bornes de la résistance R1801 ne change pas. La tension entre les bornes OT_SENSOR et SGND augmente alors, et si elle dépasse la tension de référence VREF1800, la tension de sortie du circuit comparateur C1801 augmente, ce qui entraîne la baisse de la tension de sortie, c'est-à-dire la tension entre les bornes DIAG_OT et SGND diminue aussi.

De plus, les résistances R1901, R1902 et la transistor T1901 forment un élément tampon permettant de fournir l'information d'apparition d'une surchauffe à un contrôleur externe, par exemple un microcontrôleur. La résistance R1902 est utilisée pour limiter le courant traversant le transistor T1901. En effet, dans un certain mode de fonctionnement du dispositif 400, le circuit 1900 peut être désactivé si l'utilisateur du dispositif ne veut plus avoir accès à la protection contre les surchauffes. Dans ce cas, si la borne de sortie DIAG_OT est reliée, de préférence connectée, à la borne DZ ou à la borne VDD, la résistance R1902 permet alors de réduire la tension de sortie DIAG_OT.

La figure 20 est une vue de dessus du même exemple pratique de réalisation du dispositif 400 décrit en relation avec la figure 6, dans laquelle le positionnement des résistances R1801 et R1802 est représenté selon le premier mode de réalisation décrit en relation avec la figure 18.

Comme décrit précédemment, la résistance R1801 a un coefficient de température nul et est placé au niveau du circuit de commande 450 (emplacement R2 en figure 20) de façon à être impacté au minimum par une éventuelle hausse de température du transistor 401.

La résistance R1802 a un coefficient de température positif et est placée au niveau du transistor 401 (emplacement R1 en figure 20) de façon à voir la même variation de température que le transistor 401. Ainsi, la résistance R1802 voit la tension à ses bornes augmenter en cas de surchauffe du transistor 401.

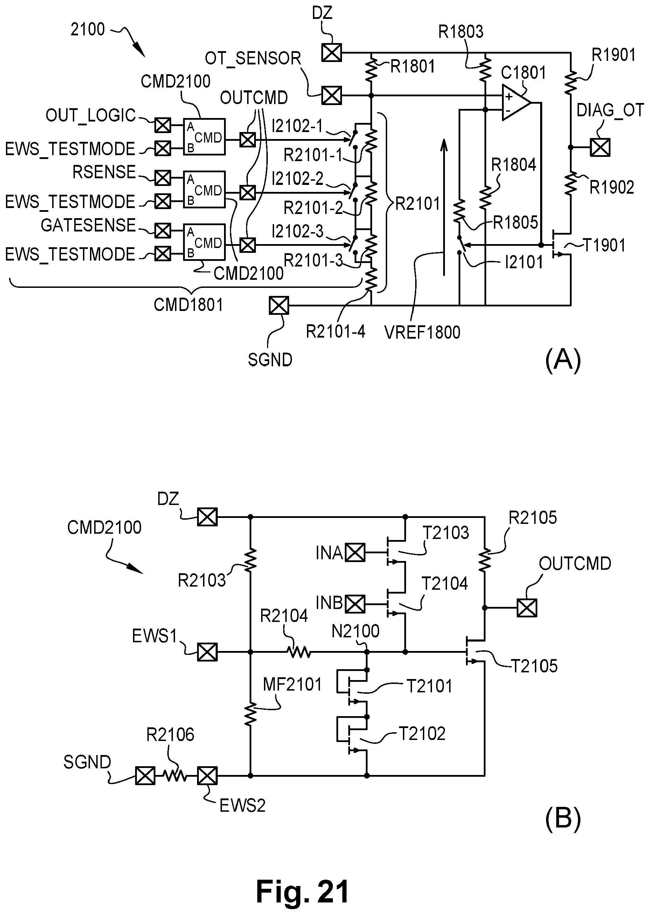

La figure 21 représente un troisième mode de réalisation, et un mode de réalisation préféré, d'un circuit protection contre les surchauffes 2100, adapté à faire partie du dispositif 400 décrit en relation avec la figure 4. La figure 21 comprend deux vues (A) et (B), la vue (A) illustre, partiellement sous forme de blocs, le circuit de protection contre les

17

surchauffes 2100, et la vue (B) illustre, une partie du circuit 2100 de protection contre les surchauffes.

Le circuit 2100 présente des éléments communs avec le circuit 1800 de la figure 18 et le circuit 1900 de la figure 19. Ces éléments ne seront pas décrits de nouveau et seules les différences entre les circuits 1800, 1900, et 2100 seront mises en exergue.

Le circuit 2100 comprend la plupart des composants du circuit 1900 mais comprend, à la place de la résistance R1802 une résistance à résistance modifiable et son circuit de commande CMD1801. De plus, dans le circuit 2100 le transistor T1801 est remplacé par un interrupteur I2101 comprenant une borne de commande reliée, de préférence connectée, seulement à la grille du transistor T1901 et non plus à la borne DIAG_OT.

En figure 21, la résistance R2101 est formée par quatre résistances R2101-1 à R2101-4, dont trois résistances R2101-1 à R2101-3 sont sélectionnables l'intermédiaire d'interrupteurs I2102-1 à I2102-3. Selon un exemple, les interrupteurs I2102-1 à I2102-3 sont mis en oeuvre par des transistors de type e-mode. La personne du métier saura ajuster le nombre de résistances formant la résistance R2101 au nombre nécessaire pour son application.

Plus particulièrement, les résistances R2101-1, R2101-2, R2101-3, et R2101-4 sont reliées en série entre les bornes OT_SENSOR et SGND. L'interrupteur I2102-1 est relié, de préférence connecté, en parallèle avec la résistance R2101-1, de façon que si l'interrupteur I2102-1 est conducteur, la résistance R2101-1 est court-circuitée. De même, l'interrupteur I2102-2 est relié, de préférence connecté, en parallèle avec la résistance R2101-2, et l'interrupteur I2102-3 est relié, de préférence connecté, en parallèle avec la résistance R2101-3. Selon un exemple, les interrupteurs I2101-1 à I2101-3 sont des transistors.

Les interrupteurs I2102-1 à I2102-3 sont chacun commandés par un circuit de commande CMD2100 détaillés en relation avec la vue (B) de la figure 21. Le circuit de commande CMD2100 comprend deux bornes d'entrée de test INA et INB, et une borne de sortie OUTCMD fournissant une tension de commande. Selon un variante, certains circuits de commande CMD2100 peuvent être reliée à la borne de commande de l'interrupteur I2102-1, I2102-2, ou I2102-3 par un circuit inverseur (non représentés en figure 21).

Le circuit de commande CMD2100 est, en outre, reliée aux bornes DZ, SGND, et à des bornes de test EWS1 et EWS2. Le circuit de commande 2100 comprend une résistance R2103 disposée entre les bornes DZ et EWS1, une résistance R2105 disposée entre les bornes DZ et OUTCMD, et une résistance R2106 disposée entre les bornes SGND et EWS2.

Le circuit de commande CMD2100 comprend, en outre, un fusible MF2101 disposée entre les bornes EWS1 et EWS2. Le fusible 2100 permet de définir de façon permanent la valeur de la résistance R2101. Un exemple plus détaillé du fusible 2100 est décrit en relation avec la figure 22.

Le circuit de commande CMD2100 comprend deux transistors T2101 et T2102 de type e-mode. La source et la grille du transistor T2101 sont reliées, de préférence connectées, à un noeud N2100. Le drain du transistor T2101 est relié, de préférence connecté, à la source et à la grille du transistor T2102. Le drain du transistor T2102 est relié, de préférence connecté, à la borne EWS2.

Le circuit de commande CMD2100 comprend deux transistors T2103 et T2104 de type e-mode, ces transistors sont des transistors de test. La source du transistor T2103 est reliée, de préférence connectée, à la borne DZ. Le drain du transistor T2103 est relié, de préférence connecté, à la source du transistor T2104. Le drain du transistor T2104 est relié, de préférence connecté, au noeud N2100. La grille du transistor T2103 est reliée, de préférence connectée, à la borne INA. La grille du transistor T2104 est reliée, de préférence connectée, à la borne INB.

Le circuit de commande CMD2100 comprend, en outre, une résistance R2104 et un transistor T2105. La résistance R2104 est disposée entre la borne EWS1 et le noeud N2100. La source du transistor T2105 est reliée, de préférence connectée, à la borne de sortie OUTCMD. Le drain du transistor T2105 est relié, de préférence connecté, à la borne EWS2. La grille du transistor T2105 est reliée, de préférence connectée, au noeud N2100.

Le circuit de commande CMD2100 commandant l'interrupteur I2102-1 reçoit sur sa borne INA la tension OUT_LOGIC, et sur sa borne INB une tension de test EWS_TESTMODE. Le circuit de commande CMD2100 commandant l'interrupteur I2102-2 reçoit sur sa borne INA une tension RSENSE, et sur sa borne INB une tension de test EWS_TESTMODE. Le circuit de commande CMD2100 commandant l'interrupteur I2102-3 reçoit sur sa borne INA une tension GATE_SENSE, et sur sa borne INB une tension de test EWS_TESTMODE.

Le fonctionnement du circuit 2100 est le même que celui du circuit 1900, mais comprend en outre une phase de programmation de la valeur de la résistance R2101. La phase de programmation comprend deux étapes, une étape d'estimation de la valeur de la résistance à programmer, et une étape de programmation.

Pendant l'étape d'estimation, les circuits de commandes CMD2100 utilisent les transistors T2103 et T2105 pour commander le transistor T2104, et donc pour commander la tension de sortie OUTCMD. Plusieurs valeurs de la résistance R2101 sont ainsi testées pour voir quelle valeur correspond le plus. Cette étape est généralement mise en oeuvre au moment de la fabrication du dispositif 400.

Pendant l'étape de programmation, les fusibles MF2101 sont laissés passant ou non en fonction de la valeur déterminée à l'étape précédente.

Permettre de programmer la valeur de la résistance R2101 permet d'apporter beaucoup plus de précision à la détection de surchauffe.

La figure 22 est une vue en coupe illustrant un mode de réalisation d'un fusible du type du fusible MF2101 décrit en relation avec la figure 21.

Le fusible est formé entre deux niveaux de métallisations du dispositif 400, et a une forme de sablier.

Lorsqu'un courant, supérieur à un courant seuil, est appliqué entre les bornes EWS1 et EWS2, le métal formant le fusible est cassé. Si le fusible est ouvert, ou non-passant, alors la tension au niveau de la grille du transistor T2104 est augmenté jusqu'à un niveau égal à la somme des tensions de seuil des transistors T2101 et T2102, ce qui rend le transistor T2104 passant. Ce qui relie la borne de sortie OUTCMD à la borne de référence SGND.

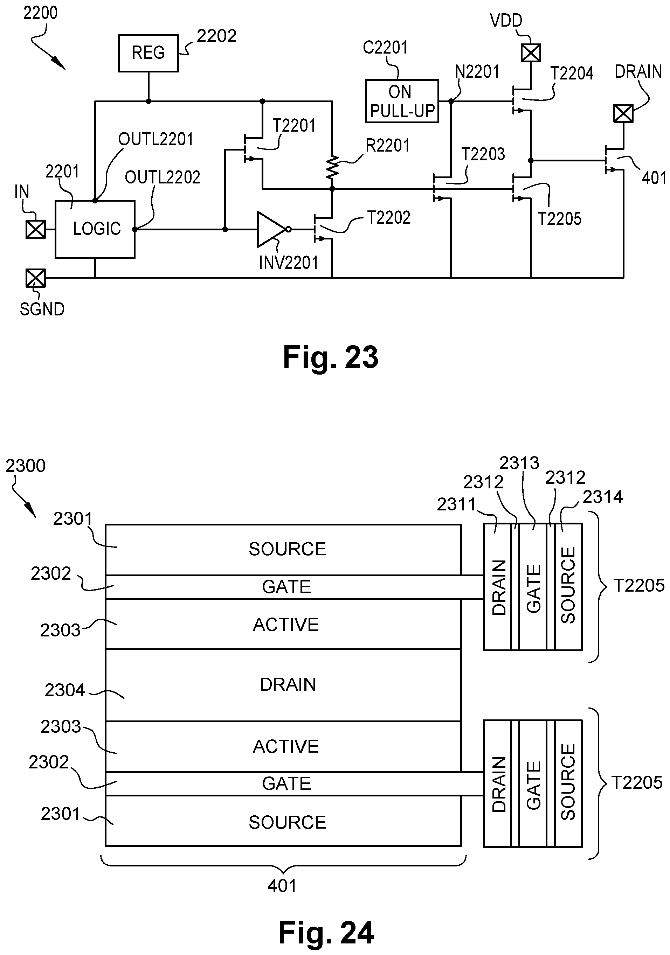

Les figures 23 à 26 représentent schématiquement, et partiellement sous forme de blocs, des modes de réalisation de circuits pouvant être un circuit de pilotage 451 décrit en relation avec la figure 4.

La figure 23 est un schéma électrique d'un premier mode de réalisation d'un circuit de pilotage 2200 adapté à faire partie du dispositif 400 décrit en relation avec la figure 4. Le circuit de pilotage 2200 forme les circuits logiques 452 et le circuit de pilotage 451 du dispositif 400.

Le circuit de pilotage 2200 est adapté à être relié à quatre bornes de connexion du dispositif 400, et plus particulièrement :

- à une borne d'entrée IN correspondant à la borne de connexion 475 du dispositif 400 ;
- à la borne VDD correspondant à la borne de connexion 476 du dispositif 400 ;
- à la borne de référence SGND correspondant à la borne de connexion 472 de référence du dispositif 400 ; et
- à la borne DRAIN correspondant à la borne interne de drain du transistor de puissance 401 du dispositif 400.

Le circuit 2200 comprend un circuit logique 2201 relié aux bornes IN et SGND, et comprend deux noeuds de sortie OUTL2201 et OUTL2202. Le circuit logique 2201 permet de transformer un signal reçu sur la borne d'entrée IN en une instruction de commande. Selon un exemple, le circuit 2201 peut être une porte logique de type "NON ET" (NAND). Selon un exemple, la sortie OUTL2201 transmet une tension d'alimentation. Selon un exemple, le circuit logique 2201 peut, en outre, recevoir en entrée les tensions DIAG_OT et VDS.

Le circuit 2200 comprend, en outre, un circuit régulateur de tension 2202 (REG) fournissant un courant au noeud OUTL2201. Le circuit 2202 peut être un des circuits régulateurs de tension décrits en relation avec les figures 7 à 16 ou l'une de leurs variantes.

Le circuit 2200 comprend, en outre, le noeud OUTL2201 et la borne SGND un transistor T2201 de type e-mode couplé en parallèle avec une résistance R2201, et un transistor T2202 de type e-mode. Plus particulièrement, le drain du transistor T2201 et une première borne de la résistance R2201 sont reliés, de préférence connectés, au noeud OUTL2201. La source du transistor T2201 et une deuxième borne de la résistance R2201 sont reliés, de préférence connectés, au drain du transistor T2202. La source du transistor T2202 est reliée, de préférence connectée, à la borne SGND. La grille du transistor T2201 est reliée, de préférence connectée, au noeud OUTL2202.

Le circuit 2200 comprend, en outre, une porte inverseuse INV2201 reliant le noeud OUTL2202 à la grille du transistor T2202.

Le circuit 2200 comprend, en outre, un circuit C2201 (ON PULL UP) d'amorçage ayant une sortie reliée à un noeud N2201 et fournissant une tension assez élevée pour commander le transistor de puissance 401 du dispositif 400. Le circuit C2201 est à la portée de la personne du métier.

Le circuit 2200 comprend, en outre, un transistor T2203 de type e-mode entre le noeud N2201 et la borne SGND. Le drain du transistor T2203 est reliée, de préférence connectée, au noeud N2201, et la source du transistor T2203 est reliée, de préférence connectée, à la borne SGND. La grille du transistor T2203 est reliée, de préférence connectée, au drain du transistor T2202.

Le circuit 2200 comprend, en outre, entre les bornes VDD et SGND deux transistors T2204 et T2205 de type e-mode. Le drain du transistor T2204 est relié, de préférence connecté, à la borne VDD, et la source du transistor T2204 est reliée, de préférence connectée, au drain du transistor T2205. La source du transistor T2205 est reliée, de préférence connectée, à la borne SGND. La grille du transistor T2204 est reliée, de préférence connectée, au noeud N2201. La grille du transistor T2205 est reliée, de préférence connectée, au drain du transistor T2202. Le transistor T2204 est un transistor de tirage (pull up transistor), et le transistor T2205 est un transistor de rappel (pull down transistor).

Pour finir, le circuit 2200 est relié au transistor de puissance 401 de la façon suivante. Le drain du transistor 401 est relié, de préférence connecté, à la borne DRAIN, et la source du transistor 401 est reliée, de préférence connectée, à la borne SGND. La grille du transistor 401 est reliée, de préférence connectée, au noeud milieu entre les transistors T2204 et T2205. De plus, le transistor T2205 est placé au plus près du transistor 401 pour favoriser la décharge de la grille du transistor 401 et/ou pour garantir une bonne communication du courant entre le transistor T2205 et la grille du transistor 401. Cela est décrit plus en détails en relation avec la figure 24.

Le fonctionnement du circuit 2200 est le suivant.

Lorsque le signal reçu par la borne IN est à un état bas, la sortie du circuit logique 2201 est à un état bas. Le transistor T2201 ne conduit pas, et le transistor T2202 conduit. Les transistors T2203 et T2205 ne sont pas conducteurs. Le transistor T2204 est conducteur. Le transistor de puissance 401 est donc conducteur.

Lorsque le signal reçu par la borne IN est à un état haut, la sortie du circuit logique 2201 est à un état haut. Selon une variante de réalisation, le circuit logique 2201 pourrait, en outre, recevoir en entrée les tensions de test fournies par les bornes DIAG_OT et DIAG_OC, si l'une de ces deux tensions est à un état haut alors la sortie du circuit logique est également à un état haut. Le transistor T2201 est alors conducteur, et le transistor T2202 ne conduit pas. Les transistors T2203 et T2205 sont conducteurs. Le transistor T2204 n'est pas conducteur. Le transistor de puissance 401 est donc non conducteur.

La figure 24 est une vue de dessus schématique d'une partie du dispositif 400 comprenant une partie du circuit de pilotage 2200 décrit en relation avec la figure 23 et une portion du transistor de puissance 401.

En figure 24, le transistor 401 est constitué d'un assemblage de plusieurs transistors de type e-mode comme décrit en relation avec la figure 5. Ces transistors comprennent chacun des régions de source 2301 (SOURCE), de grille 2302 (GATE) et de drain 2304 (DRAIN) formées sur une région active 2303 (ACTIVE) d'une structure du type de la structure 100 de la figure 1.

De plus, comme le transistor 401, le transistor T2205 est aussi composé d'un assemblage de plusieurs transistors de même type. Ces transistors comprennent chacun des régions de source 2311 (SOURCE), de grille 2312 (GATE) et de drain 2314 (DRAIN) formées sur une région active 2313 de la structure.

Selon un mode de réalisation, et pour éviter au maximum les pertes de courant, les transistors T2205 sont disposés au plus près du transistor 401, et ont pour cela leurs régions de drain 2311 en contact direct avec les régions de grilles du transistors 401.

La figure 25 représente un deuxième mode de réalisation d'un circuit de pilotage 2400, adapté à faire partie du dispositif 400 décrit en relation avec la figure 4.

Le circuit 2400 présente des éléments communs avec le circuit 2200 de la figure 23. Ces éléments ne seront pas décrits de nouveau et seules les différences entre les circuits 2200 et 2400 seront mises en exergue.

Le circuit 2400 se diffère du circuit 2200 en ce qu'il comprend un transistor T2401. Le drain du transistor T2401 est relié, de préférence connecté, au drain du transistor T2201, et la source du transistor T2401 est reliée, de préférence connectée, à la première borne de la résistance R2201. La première borne de la résistance R2201 n'est plus reliée au drain du transistor T2201 que par l'intermédiaire du transistor T2401, la deuxième borne de la résistance R2201 étant toujours reliée au drain du transistor T2202. La grille du transistor 2401 est reliée, de préférence connectée, à la source du transistor T2201. Ajouter le transistor T2401 permet d'ajouter une source de courant et de réduire la taille de la résistance R2201. Le courant fourni est égal au rapport entre la tension de seuil du transistor T2401 et de la résistance de la résistance R2201.

La figure 26 représente un deuxième mode de réalisation d'un circuit de pilotage 2500, adapté à faire partie du dispositif 400 décrit en relation avec la figure 4.

Le circuit 2500 présente des éléments communs avec le circuit 2200 de la figure 23 et le circuit 2400 de la figure 25. Ces éléments ne seront pas décrits de nouveau et seules les différences entre les circuits 2200, 2400, et 2500 seront mises en exergue.

Le circuit 2500 si diffère du circuit 2200 en ce qu'il comprend une porte AND2501 de type "ET" (AND) permettant de commander le transistor T2201.

La porte AND2501 comprend deux entrées, une première étant reliée au noeud OUTL2202 et une deuxième étant reliée à la grille du transistor 401.

L'ajout de la porte AND2501 permet d'éviter l'apparition de court-circuit au niveau des transistors T2201 et T2202 pendant une transition d'un état haut à un état bas de la tension au niveau du noeud OUTL2202.

Les figures 27 à 29 représentent schématiquement, et partiellement sous forme de blocs, un mode de réalisation d'un circuit pouvant être un circuit de protection contre les surintensités 453 décrit en relation avec la figure 4.

La figure 27 est un schéma électrique d'un mode de réalisation d'un circuit de protection contre les surintensités 2600 adapté à faire partie du dispositif 400 décrit en relation avec la figure 4. Sont représentés en figure 27, le circuit de protection contre les surintensités 2600, le transistor de puissance 401 et son circuit de pilotage 451 du dispositif 400.

Le circuit de protection contre les surintensités 2600 est adapté à être relié à cinq bornes de connexion du dispositif 400, et plus particulièrement :

- à une borne de drain DRAIN du transistor 401 correspondant à la borne de connexion 470 du dispositif 400 ;
- à la borne de référence SGND correspondant à la borne de connexion 472 de référence du dispositif 400 ; et
- à une borne de référence OUT_LOGIC correspondant à la borne interne de connexion 452OUT de sortie des circuits logiques 452 du dispositif 400 ; et
- à une borne de test DIAG_OC correspondant à la borne de connexion 473 de test du dispositif 400 ;
- à la borne DZ correspondant à la borne de connexion 477 du dispositif 400, ou, selon une variante à la borne VDD ;
- à une borne VSUPP correspondant à une borne d'alimentation interne du dispositif 400 ; et

- à une borne IN_LOGIC correspondant à la borne interne de connexion 452IN d'entrée des circuits logiques 452 du dispositif 400.

Le transistor de puissance 401 a son drain relié, de préférence connecté, à la borne DRAIN, et a sa source reliée, de préférence connectée, à la borne SGND. Le transistor 401 reçoit sur sa grille une tension de commande de la part du circuit de pilotage 451.

Le circuit 2600 comprend un circuit convertisseur de niveau LS2601 (LS) (Level Shifter) comprenant deux entrées et une sortie. La première entrée du circuit 2600 est reliée, de préférence connectée, à la borne OUT_LOGIC.

Le circuit 2600 comprend, en outre, sur une première branche entre les bornes DRAIN et SGND, un transistor T2601 de type e-mode et une résistance R2601. Le drain du transistor T2601 est relié, de préférence connecté, à la borne DRAIN, et la source du transistor T2601 est reliée, de préférence connectée, à une première borne de la résistance R2601. Une deuxième borne de la résistance R2601 est reliée, de préférence connectée, à la borne SGND. La grille du transistor T2601 est reliée, de préférence connectée, à la sortie du circuit convertisseur de niveau LS2601.

Le circuit 2600 comprend, en outre, sur une deuxième branche entre les bornes VSUPP et SGND, une résistance R2602 et un transistor T2602 de type e-mode. Une première borne de la résistance R2602 est reliée, de préférence connectée à la borne VSUPP, et une deuxième borne de la résistance R2602 est reliée, de préférence connectée, au drain du transistor T2602. La source du transistor T2602 est reliée, de préférence connectée, à la borne SGND, et la grille du transistor T2602 est reliée, de préférence connectée à la deuxième entrée du circuit convertisseur de tension LS2601.

Selon un mode de réalisation, le transistor T2602 est un transistor frère du transistor de puissance 401, c'est-à-dire que le transistor T2602 est un transistor de même type que le transistor 401, et, de plus, les dimensions du transistor T2602 sont environ 10000 fois plus petites que les dimensions du transistor 401.

Les transistors T2601 et T2602 sont des transistors adaptés aux hautes tensions, c'est-à-dire adaptés à supporter entre leur source et leur drain une tension de l'ordre de 650 V. De plus, les transistors 401 et T2602 sont fabriqués en parallèle en mettant en oeuvre les mêmes procédés.

Le circuit 2600 comprend, en outre, un circuit comparateur C2601 adapté à comparer de tensions des première et deuxième branches. Plus particulièrement, le circuit comparateur C2601 comprend une première entrée (+) reliée, de préférence connectée, au noeud milieu entre le transistor T2601 et la résistance R2601, et une deuxième entrée (-) reliée, de préférence connectée, au noeud milieu entre la résistance R2602 et le transistor T2602. Un exemple détaillé de circuit comparateur est décrit en relation avec la figure 17. Ainsi, le circuit comparateur compare la tension aux bornes de la résistance R2601, appelée tension VDS_SENSE, et la tension aux bornes du transistor T2602, appelée tension VRSENSE. La tension VRSENSE représente la tension de référence par rapport à laquelle la tension VDS_SENSE est comparée, et est donnée par la formule mathématique suivante :

[Math 8]

$$VRSENSE = \frac{6 * R(T2602)}{R(T2602) + R2602}$$

dans laquelle :

- R(T2602) représente la résistance interne du transistor T2602 ; et
- R2602 représente la résistance de la résistance R2602.

Le circuit 2600 comprend, en outre, sur une troisième branche entre les bornes DZ et SGND, deux résistances R2603 et R2604 et un transistor T2603 de type e-mode. Une première borne de la résistance R2603 est reliée, de préférence connectée à la borne DZ, et une deuxième borne de la résistance R2603 est reliée, de préférence connectée, à la borne DIAG_OC. Une première borne de la résistance R2604 est reliée, de préférence connectée à la borne DIAG_OC, et une deuxième borne de la résistance R2604 est reliée, de préférence connectée, au drain du transistor T2603. La source du transistor T2603 est reliée, de préférence connectée, à la borne SGND, et la grille du transistor T2603 est reliée, de préférence connectée à la sortie du circuit comparateur C2601.

Le circuit 2600 comprend, en outre, sur une quatrième branche entre les bornes DIAG_OC et SGND, une résistance R2605 et un transistor T2604 de type e-mode. Une première borne de la résistance R2605 est reliée, de préférence connectée à la borne DIAG_OC, et une deuxième borne de la résistance R2605 est reliée, de préférence connectée, au drain du transistor T2604. La source du transistor T2604 est reliée, de préférence connectée, à la borne SGND, et la grille du transistor T2604 est reliée, de préférence connectée à la borne IN_LOGIC.

Le circuit 2600 comprend, en outre, sur une cinquième branche entre les bornes DZ et SGND, une résistance R2606 et un transistor T2605 de type e-mode. Une première borne de la résistance R2606 est reliée, de préférence connectée à la borne DZ, et une deuxième borne de la résistance R2606 est reliée, de préférence connectée, au drain du transistor T2605 et à la borne IN_LOGIC. La source du transistor T2605 est reliée, de préférence connectée, à la borne SGND, et la grille du transistor T2605 est reliée, de préférence connectée à la borne DIAG_OC.

Le fonctionnement du circuit 2600 est décrit en relation avec la figure 28.

La figure 28 représente des chronogrammes de tensions et courant du circuit 2600 et du dispositif 400.

Plus particulièrement, le figure 27 comprend :

- une tension d'entrée V(IN) représentant la tension au niveau de la borne de connexion 475 (IN) du dispositif 400 ;
- une tension V(DS) représentant la tension au niveau des bornes de conduction du transistor de puissance 401 du dispositif 400 ;
- un courant I(DS) représentant le courant entre les bornes de conduction du transistor de puissance 401 du dispositif 400 ; et
- une tension V(DIAG_OC) représentant la tension au niveau de la borne de test 473 du dispositif 400.

A un instant initial t0, la tension d'entrée V(IN) est à un état haut, par exemple à 6 V, et le transistor 401 est donc non conducteur. Le courant traversant le transistor 401 est inférieur à un courant de seuil IDS_TH, et la tension V(DS) aux bornes du transistor 401 est à un état haut, par exemple 6 V, et constante.

A un instant t1, postérieur à l'instant t0, la tension V(IN) passe à un état bas, le transistor 401 devient conducteur, la tension V(DS) passe sous une tension seuil VDS_TH. Les grilles des transistors 401, T2601, T2602, et T2603 reçoivent une tension inférieure aux tensions de seuil de ces transistors. La grille du transistor T2604 reçoit toujours une tension haute, et le transistor T2604 force la tension V(DIAG_OC) à rester à un état haut.

Entre l'instant t1 et un instant t2, postérieur à l'instant t1, le courant I(DS) augmente, par exemple suite à un court-circuit dans le dispositif 400. A l'instant t2, le courant I(DS) dépasse le courant de seuil IDS_TH. Le comparateur C2601 le détecte et la tension V(DIAG_OC) passe à un état bas à l'instant t2.

Entre l'instant t2 et un instant t3, postérieur à l'instant t2, le tension V(DIAG_OC) reste à l'état bas, et le circuit 2600 force le transistor 401 à être non conducteur. La tension V(DS) passe alors à un état haut, et le courant I(DS) décroit jusqu'à revenir à son état initial. La tension V(DIAG_OC) alerte alors les circuits du dispositif 400 en restant à l'état bas.

Après l'instant t3, la tension V(DIAG_OC) repasse à un état haut, et l'alerte est terminée.

La figure 29 est une vue de dessus du même exemple pratique de réalisation du dispositif 400 décrit en relation avec les figures 6 et 20, dans laquelle le positionnement transistor T2602 est représenté selon un mode de réalisation.

Le transistor T2602 est placé entre deux des assemblages formant le transistor 401. En étant situé ainsi, le transistor T2602 est adapté à recevoir le même courant que le transistor de puissance 401.

Un avantage de ce mode de réalisation est qu'il permet de fournir une protection contre les surintensités ayant un temps de réponse assez rapide pour qu'une surintensités ne provoque pas de dégât au niveau du transistor de puissance 401.

Les figures 30 à 32 représentent très schématiquement des modes de réalisation de bornes de connexion pouvant être une des bornes de connexion 470 à 478du dispositif 400 décrit en relation avec la figure 4.

La figure 30 décrit d'une structure 2900 comprenant un premier mode de réalisation d'une borne de connexion pouvant faire partie du dispositif 400.

La structure 2900 comprend la structure 100 décrite en relation avec la figure 1, et comprend un substrat 101 recouvert d'une couche de Nitrure de Gallium 102.

La structure 2900 comprend, en outre, sur la structure 100, un empilement 2900M formant des niveaux de métallisations, en particulier trois niveaux de métallisations en figure 30. Plus particulièrement, l'empilement 2900 comprend :

- une couche 2901 isolante électriquement reposant sur et en contact avec la couche 102 de la structure 100 ;
- une couche 2902 conductrice électriquement, par exemple une couche métallique, reposant sur et en contact avec la couche 2901 ;
- une couche 2903 isolante électriquement reposant sur et en contact avec la couche 2902 ;
- une couche 2904 conductrice électriquement, par exemple une couche métallique, reposant sur et en contact avec la couche 2903 ;
- une couche 2905 isolante électriquement reposant sur et en contact avec la couche 2904 ; et
- une couche 2906 conductrice électriquement, par exemple une couche métallique, reposant sur et en contact avec la couche 2905.

La couche 2906 est utilisée pour former une borne de connexion, et est reliée à un noeud I/O. La borne de connexion peut être reliée à d'autre borne de connexion par exemple par un procédé de soudure par fil.

Selon un mode de réalisation, la couche conductrice 2902 est reliée, de préférence connectée à la borne de source du transistor de puissance 401.

Le borne de connexion formée par la couche 2906 est protégée électriquement de la structure 100, et des composants qui sont susceptibles d'y être formés, par les capacités parasites formées par les couches isolantes 2901, 2903 et 2905.

La figure 31 décrit une structure 3000 comprenant un deuxième mode de réalisation d'une borne de connexion pouvant faire partie du dispositif 400.

La structure 3000 comprends des éléments communs avec la structure 2900 décrite en relation avec la figure 30. Ces éléments communs ne seront pas décrits de nouveau, et seules les différences entre les structures 2900 et 3000 seront mises en exergue.

A la différence de la structure 2900, la structure 3000 ne comprend que deux niveaux de métallisations, et, ainsi, ne comprend pas les couches 2905 et 2906. La borne de connexion est formé dans la couche 2904.

Le borne de connexion formée par la couche 2904 est protégée électriquement de la structure 100, et des composants qui sont susceptibles d'y être formés, par les capacités parasites formées par les couches isolantes 2901 et 2903.

La figure 32 décrit une structure 3100 comprenant un third mode de réalisation d'une borne de connexion pouvant faire partie du dispositif 400.

La structure 3100 comprend des éléments communs avec la structure 2900 décrite en relation avec la figure 30 et avec la structure 3000 décrite en relation avec la figure 31. Ces éléments communs ne seront pas décrits de nouveau, et seules les différences entre les structures 2900 et 3000 seront mises en exergue.

Comme la structure 2900, la structure 3100 comprend trois niveaux de métallisations, mais comprend, en outre, des vias 3101 conducteurs électriquement reliant la couche 2906 à la couche 2905. La borne de connexion est toujours formée dans la couche 2906.

Le borne de connexion formée par la couche 2906 est protégée électriquement de la structure 100, et des composants qui sont susceptibles d'y être formés, par les capacités parasites formées par les couches isolantes 2901 et 2903.

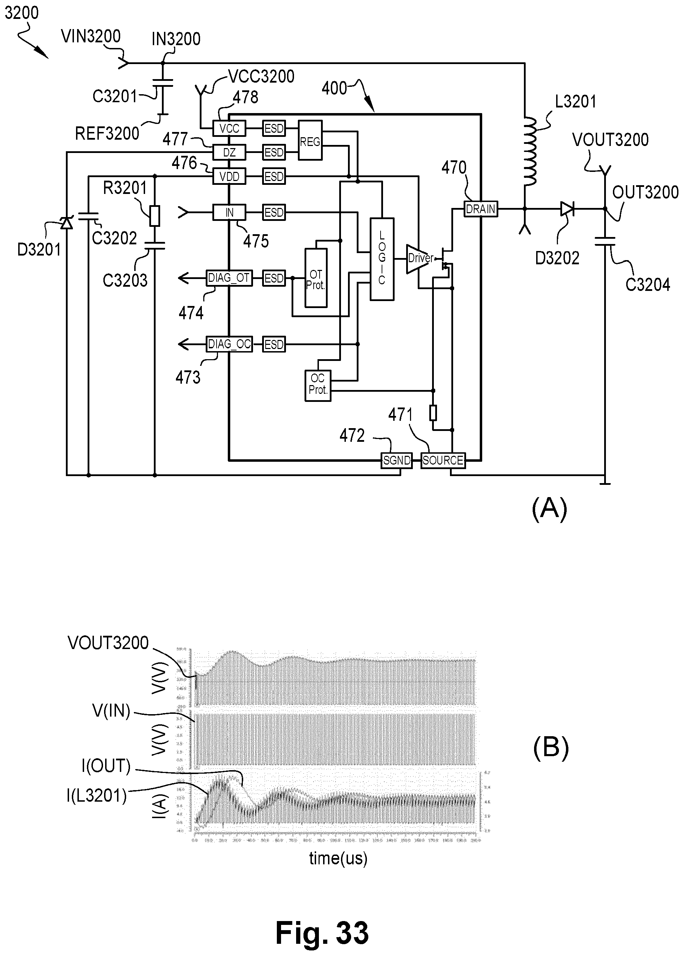

Les figures 33 à 35 présentent des modes de réalisation d'applications du dispositif 400 décrits en relation avec les figures 4 à 31.

La figure 33 représente, schématiquement et partiellement sous forme de blocs, un premier mode de réalisation d'une application du dispositif 400. Plus particulièrement, la figure 32 comprend une vue (A) illustrant un schéma électrique du premier mode de réalisation, et une vue (B) illustrant des chronogrammes illustrant le fonctionnement du premier mode de réalisation. En vue (A), le dispositif 400 est représenté sous forme de blocs de la même façon qu'en figure 4. Toutes les variantes des circuits du dispositif 400 décrites en relation avec es figures 5 à 32 sont applicables ici.

En vue (A), le dispositif 400 est utilisé dans un système électronique 3200 pour former circuit convertisseur Boost (Boost Converter), c'est-à-dire une alimentation à découpage adaptée à convertir une tension VIN3200 d'entrée continue en une tension VOUT3200 de sortie continue de plus forte valeur. Selon un exemple, la tension VIN3200 est de l'ordre de 220 V ou de 311 V. Selon un exemple, la tension VOUT3200 est de l'ordre de 400 V.

Le système 3200 comprend le dispositif 400. La borne d'entrée 475 (IN) du dispositif 400 recevant une tension de commande de la part, par exemple, d'un processeur externe au système 3200. La borne 478 (VCC) reçoit un potentiel d'alimentation VCC3200. Les bornes de test 474 (DIAG_OT) et 473 (DIAG_OC) sont utilisées comme bornes de test du système 200.

Le système 3200 comprend, en outre, un transistor d'entrée C3201 disposé entre le noeud d'entrée IN2300, recevant la tension d'entrée VIN2300, et un noeud de référence REF3200. Ainsi, une première borne du condensateur C3201 est reliée, de préférence connectée, au noeud IN2300, et une deuxième borne du condensateur C3201 est reliée, de préférence connectée, au noeud de référence REF3200. Le condensateur C3201 est un condensateur de filtrage.

Le système 3200 comprend, en outre, entre le noeud d'entrée IN2300 et la borne de drain 470 (DRAIN) du dispositif 400, une bobine L3201 de sortie. Une première borne de la bobine L3201 est reliée, de préférence connectée au noeud IN3200, et une deuxième borne de la bobine 3201 est reliée, de préférence connectée, à la borne 470 du dispositif 400. La bobine L3201 est utilisé comme convertisseur d'une tension continue en une tension continue. Plus particulièrement, la bobine L3201 stocke de l'énergie et permet de créer un rail d'alimentation supplémentaire.

Le système 3200 comprend, en outre, entre la borne 477 (DZ) et la borne 472 de référence du dispositif 400, une diode Zener D3201. La cathode de la diode Zener 3201 est reliée, de préférence connectée, à la borne 477, et l'anode de la diode Zener D3201 est reliée, de préférence connectée, à la borne 472. La diode D3201 peut représenter la diode externe utilisée dans les circuits régulateurs de tension et de haute tension du dispositif 400.

Le système 3200 comprend, en outre, entre la borne 476 (VDD) et la borne 472 de référence du dispositif 400, un condensateur C3202 de filtrage. Un première borne du condensateur C3202 est reliée, de préférence connectée, à la borne 476, et une deuxième du condensateur C3202 est reliée, de préférence connectée à la borne 472.

Le système 3200 comprend, en outre, de façon optionnelle, entre la borne 476 (VDD) et la borne 472 de référence du dispositif 400, une résistance R3201 et un condensateur C3203. Un première borne de la résistance R3201 est reliée, de préférence connectée, à la borne 476, et une deuxième de la résistance R3201 est reliée, de préférence connectée à une première borne du condensateur C3203. Un deuxième borne du condensateur C3203 est reliée, de préférence connectée, à la borne 472.

Le système 3200 comprend, en outre, entre la borne de drain 470 et la borne 471 du dispositif 400, une diode D3202 de Schottky et un condensateur de sortie C3204. L'anode de la diode D3202 est reliée, de préférence connectée, à la borne de 470, et la cathode de la diode D3202 est reliée, de préférence connectée, au noeud de sortie OUT3200 du système 3200, fournissant la tension de sortie VOUT3200, et à une première borne du condensateur C3206. La deuxième borne du condensateur C3206 est reliée, de préférence connectée, à la borne 471.

Le fonctionnement du système 3200 est décrit en relation avec la vue (B). La vue (B) comprend les chronogrammes suivants :

- le chronogramme de la tension de sortie VOUT3200 ;
- le chronogramme de la tension de de commande V(IN) reçue par la borne 475 ;
- le chronogramme du courant de sortie I(OUT) ; et
- le chronogramme du courant I(L3201) traversant la bobine L3201.

La tension de commande V(IN) est une tension créneau oscillant entre un état haut et un état bas. La tension de sortie VOUT3200 est aussi une tension créneau dont la tension maximale se stabilise petit à petit. Plus particulièrement, au démarrage du système 3200, tous les circuits régulateurs de tension ne sont pas directement opérationnels. La tension de sortie VOUT3200 et le courant de sortie I(OUT) présentent donc une allure pseudopériodique le temps que tous les circuits régulateurs de tension démarrent, puis se stabilisent chacun en un signal créneau alternant entre un état haut et un état bas.

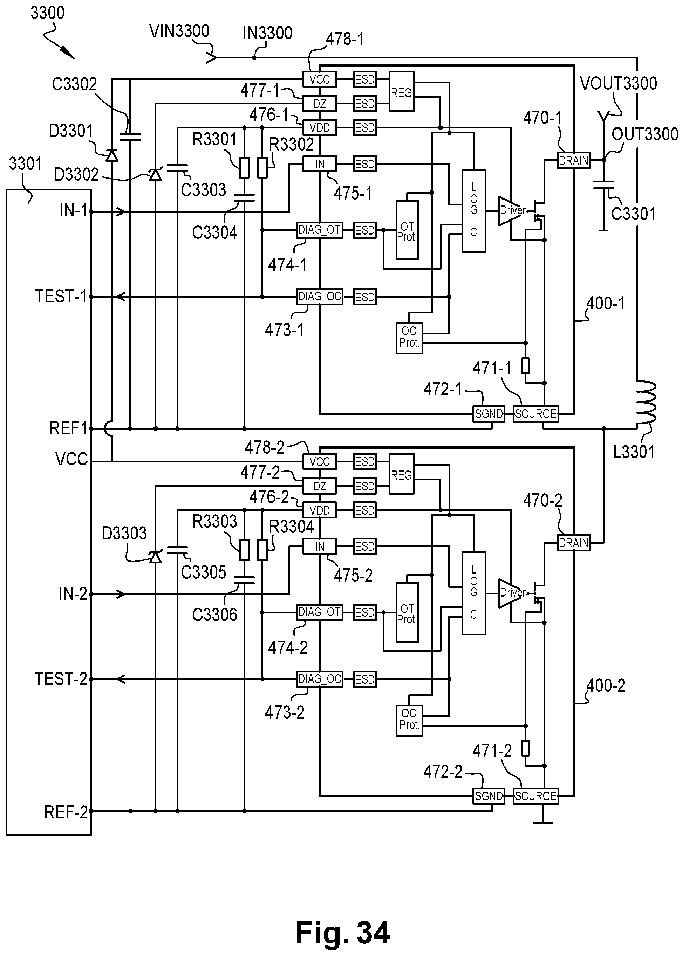

La figure 34 représente, schématiquement et partiellement sous forme de blocs, un deuxième mode de réalisation d'une application du dispositif 400. En figure 34, le dispositif 400 est représenté sous forme de blocs de la même façon qu'en figure 4. Toutes les variantes des circuits du dispositif 400 décrites en relation avec es figures 5 à 31 sont applicables ici.

En figure 34, le dispositif 400 est utilisé dans un système électronique 3300 pour former circuit convertisseur symétrique, ou convertisseur en push-pull à configuration en demi-pont (Half bridge configuration), c'est-à-dire un circuit adapté à convertir une tension VIN3300 d'entrée continue en une tension VOUT3300 de sortie continue. Selon un exemple, la tension VIN3200 est de l'ordre de 220 V ou de 311 V. Selon un exemple, la tension VOUT3200 est de l'ordre de 400 V.

Le système 3300 comprend deux dispositifs 400, référencés en figure 34 dispositifs 400-1 et 400-2. Les éléments relatifs au dispositif 400-1 ont le suffixe "-1" en fin de référence, et les éléments relatifs au dispositif 400-2 ont le suffixe "-2" en fin de référence.

Le système 3300 comprend, en outre, un circuit de commande 3301 adapté à mettre en oeuvre les dispositifs 400-1 et 400-2. Le circuit de commande 3301 comprend les bornes suivantes :

- une borne d'entrée IN-1 reliée, de préférence connectée, à la borne d'entrée 475-1 (IN) du dispositif 400-1 ;
- une borne de test TEST-1 reliée, de préférence connectée, aux bornes de test 474-1 (DIAG_OT) et 473-1 (DIAG_OC) du dispositifs 400-1 ;
- une première borne de référence REF-1 reliée, de préférence connectée, à la borne 472-1 (SGND) du dispositif 400-1 ;
- une borne d'alimentation VCC reliée, de préférence connectée, à la borne 478-2 (VCC) du dispositif 400-2 ;
- une borne d'entrée IN-2 reliée, de préférence connectée, à la borne d'entrée 475-2 (IN) du dispositif 400-2 ;
- une borne de test TEST-2 reliée, de préférence connectée, aux bornes de test 474-2 (DIAG_OT) et 473-2 (DIAG_OC) du dispositifs 400-2 ; et
- une première borne de référence REF-2 reliée, de préférence connectée, à la borne 472-2 (SGND) du dispositif 400-2.

Le système 3300 comprend, en outre, entre le noeud d'entrée IN3300, recevant la tension d'entrée VIN3300, et le noeud 471-1 du dispositif 400-1, et le noeud 470-2 du dispositif 400-2, une bobine L3301. Une première borne de la bobine L3301 est reliée, de préférence connectée au noeud IN3300, et une deuxième borne de la bobine L3301 est reliée, de préférence connectée, aux bornes 471-1 et 470-2. La bobine L3301 est utilisée comme convertisseur d'une tension continue en une tension continue. Plus particulièrement, la bobine L3301 stocke de l'énergie et permet de créer un rail d'alimentation supplémentaire.

Le système 3300 comprend, en outre, entre le noeud de sortie OUT3300, fournissant la tension de sortie VOUT3300, et le noeud 470-1 du dispositif 400-1, un condensateur C3301. Une première borne du condensateur C3301 est reliée, de préférence connectée au noeud OUT3300, et une deuxième borne du condensateur C3301 est reliée, de préférence connectée, à une borne de référence.

Le système 3300 comprend, en outre, entre la borne 478-1 du dispositif 400-1, la borne d'alimentation VCC du circuit de commande et la borne 478-2 du dispositif 400-2, une diode D3301. La cathode la diode D3301 est reliée, de préférence connectée, à la borne 478-1, et l'anode de la diode D3301 est reliée, de préférence connectée, à la borne VCC et à la borne 478-2.

Le système comprend, en outre, entre la borne 478-1 du dispositif 400-1 et la borne d'alimentation VCC du circuit de commande 301, un condensateur C3302. Une première borne du condensateur C3302 est reliée, de préférence connectée, à la borne 478-1, et une deuxième borne du condensateur C3302 est reliée, de préférence connectée, à la borne VCC. Le condensateur C3302 est utilisé pour décaler une tension de niveaux (bootstrap capacitor). Plus particulièrement, le condensateur C3302 permet de modifier la tension au niveau de la borne VCC, d'une tension référencée par rapport à la tension de la borne 472-1, en une tension référencée par rapport à une tension de référence de sortie.

Le système 3300 comprend, en outre, entre la borne 477-1 du dispositif 400-1, et la borne REF-1 du dispositif 400-1, une diode Zener D3302. La cathode de la diode D3302 est reliée, de préférence connectée, à la borne 477-1, et l'anode de la diode D3302 est reliée, de préférence connectée, à la borne REF-1.

Le système 3300 comprend, en outre, entre la borne 476-1 du dispositif 400-1, et la borne REF-1 du dispositif 400-1, un condensateur C3303. Une première borne du condensateur C3303 est reliée, de préférence connectée, à la borne 476-1, et une deuxième borne du condensateur C3303 est reliée, de préférence connectée, à la borne REF-1. Le condensateur C3303 permet d'alimenter la circuit de pilotage du dispositif 400-1.

Le système 3300 comprend, en outre et de façon optionnelle, entre la borne 476-1 du dispositif 400-1, et la borne REF-1 du dispositif 400-1, une résistance R3301 et un condensateur C3304. Une première borne de la résistance R3301 est reliée, de préférence connectée, à la borne 476-1, et une deuxième borne de la résistance R3301 est reliée, de préférence connectée, à une première borne du condensateur C3304. Une deuxième borne du condensateur C3304 est reliée, de préférence connectée, à la borne REF-1.

Le système comprend, en outre, entre la borne 476-1 du dispositif 400-1 et les bornes 474-1 et 473-1 du dispositif 400-1, une résistance R3302. Une première borne de la résistance R3302 est reliée, de préférence connectée, à la borne 476-1, et une deuxième borne de la résistance R3302 est reliée, de préférence connectée, aux bornes 474-1 et 473-1. La résistance R3302 est une résistance de rappel permettant de créer une fonction logique de type NON-OU prenant en entrée les tensions de sorties des bornes 474-1 et 473-1.

Le système 3300 comprend, en outre, entre la borne 477-2 du dispositif 400-2, et la borne REF-2 du dispositif 400-2, une diode Zener D3303. La cathode la diode D3303 est reliée, de préférence connectée, à la borne 477-2, et l'anode de la diode D3303 est reliée, de préférence connectée, à la borne REF-2.

Le système 3300 comprend, en outre, entre la borne 476-2 du dispositif 400-2, et la borne REF-2 du dispositif 400-2, un condensateur C3305. Une première borne du condensateur C3305 est reliée, de préférence connectée, à la borne 476-2, et une deuxième borne du condensateur C3305 est reliée, de préférence connectée, à la borne REF-2. Le condensateur C3305 permet de polariser la tension de sortie du circuit de pilotage du dispositif 400-2.

Le système 3300 comprend, en outre et de façon optionnelle, entre la borne 476-2 du dispositif 400-2, et la borne REF-2 du dispositif 400-2, une résistance R3303 et un condensateur C3306. Une première borne de la résistance R3303 est reliée, de préférence connectée, à la borne 476-2, et une deuxième borne de la résistance R3303 est reliée, de préférence connectée, à une première borne du condensateur C3306. Une deuxième borne du condensateur C3306 est reliée, de préférence connectée, à la borne REF-2.

Le système comprend, en outre, entre la borne 476-2 du dispositif 400-2 et les bornes 474-2 et 473-2 du dispositif 400-2, une résistance R3304. Une première borne de la résistance R3304 est reliée, de préférence connectée, à la borne 476-2, et une deuxième borne de la résistance R3304 est reliée, de préférence connectée, aux bornes 474-2 et 473-2. La résistance R3304 est une résistance de rappel permettant de créer une fonction logique de type NON-OU prenant en entrée les tensions de sorties des bornes 474-2 et 473-2.

Le fonctionnement du système 3300 est décrit en relation avec la figure 35.

La figure 35 illustre des chronogrammes de tension et de courant du système 3300 décrit en relation avec la figure 34. La figure 35 comprend les chronogrammes suivants :

- le chronogramme de la tension de sortie VOUT3300 ;
- le chronogramme de la tension de de commande V(IN-1) reçue par la borne 475-1 ;
- le chronogramme de la tension de de commande V(IN-2) reçue par la borne 475-2 ;
- le chronogramme du courant de sortie I(OUT) ; et
- le chronogramme du courant I(L3301) traversant la diode L3201.

Les tensions de commande V(IN-1) et V(IN-2) sont des tensions créneau oscillant entre un état haut et un état bas. La tension de sortie VOUT3300 est aussi une tension créneau dont la tension maximale se stabilise petit à petit.

Plus particulièrement, au démarrage du système 3300, tous les circuits régulateurs de tension ne sont pas directement opérationnels. La tension de sortie VOUT3300 et le courant de sortie I(OUT) présentent donc une allure pseudopériodique le temps que tous les circuits régulateurs de tension démarrent, puis se stabilisent chacun en un signal créneau alternant entre un état haut et un état bas.

La figure 36 représente, schématiquement et partiellement sous forme de blocs, un troisième mode de réalisation d'une application du dispositif 400. En figure 36, le dispositif 400 est représenté sous forme de blocs de la même façon qu'en figure 4. Toutes les variantes des circuits du dispositif 400 décrites en relation avec es figures 5 à 31 sont applicables ici.

En figure 36, le dispositif 400 est utilisé dans un système électronique 3400 pour former un circuit convertisseur de tension adapté à convertir une tension VIN3200 d'entrée continue en une tension VOUT3400 de sortie continue. Selon un exemple, la tension VIN3400 est de l'ordre de 220 V ou de 311 V. Selon un exemple, la tension VOUT3200 est de l'ordre de 400 V.

Le système 3400 comprend le dispositif 400. Le dispositif 400 comprend, dans ce mode de réalisation, une borne supplémentaire 3401 (SUPPLY) d'alimentation. La borne 3401 est reliée, de préférence connectée, à un noeud IN3400 recevant la tension d'entrée VIN3400.

Le système 3400 comprend, en outre, un condensateur d'entrée C3401 disposé entre le noeud d'entrée IN2300 et un noeud de référence REF3400. Ainsi, une première borne du condensateur C3401 est reliée, de préférence connectée, au noeud IN2300, et une deuxième borne du condensateur C3401 est reliée, de préférence connectée, au noeud de référence REF3400.

Le système 3400 comprend, en outre, entre le noeud d'entrée IN2300 et la borne de drain 470 (DRAIN) du dispositif 400, une bobine L3401 de sortie. Une première borne de la bobine L3401 est reliée, de préférence connectée au noeud IN3400, et une deuxième borne de la bobine 3401 est reliée, de préférence connectée, à la borne 470 du dispositif 400. La bobine L3401 forme un premier enroulement d'un transformateur fournissant la tension de sortie VOUT3400 du système 3400.

Le système 3400 comprend, en outre, un deuxième partie du transformation dont fait partie la bobine L3401. Cette partie comprend une bobine L3402, formant un deuxième enroulement du transformateur, une diode D3401 et un condensateur C3402. Une première borne de la bobine L3402 est reliée, de préférence connectée, à l'anode de la diode D3401, et la cathode de la diode D3401 est reliée, de préférence connectée, à un noeud OUT3400 fournissant la tension de sortie VOUT3400. Une deuxième borne de la bobine L3402 est reliée, de préférence connectée à une première borne du condensateur C3402, et une deuxième borne du condensateur C3402 est reliée, de préférence connectée au noeud C3402.

Le système 3400 comprend, en outre, un troisième partie du transformation dont fait partie les bobines L3401 et L3402. Cette partie comprend une bobine L3403, formant un troisième enroulement du transformateur, une diode D3402 et un condensateur C3403. Une première borne de la bobine L3403 est reliée, de préférence connectée, à l'anode de la diode D3402, et la cathode de la diode D3402 est reliée, de préférence connectée, à la borne 478 du dispositif 400. Une deuxième borne de la bobine L3403 est reliée, de préférence connectée à une première borne du condensateur C3403, et une deuxième borne du condensateur C3403 est reliée, de préférence connectée à la borne 478.

Le système 3400 comprend, en outre, entre la borne 477 (DZ) et la borne 472 de référence du dispositif 400, une diode Zener D3403. La cathode de la diode Zener 3403 est reliée, de préférence connectée, à la borne 477, et l'anode de la diode Zener D3403 est reliée, de préférence connectée, à la borne 472. La diode D3403 peut représenter la diode externe utilisée dans les circuits régulateurs de tension et de haute tension du dispositif 400.

Le système 3400 comprend, en outre, entre la borne 476 (VDD) et la borne 472 de référence du dispositif 400, un condensateur C3404 de filtrage. Un première borne du condensateur C3404 est reliée, de préférence connectée, à la borne 476, et une deuxième du condensateur C3404 est reliée, de préférence connectée à la borne 472.

Le système 3400 comprend, en outre et façon optionnelle, entre la borne 476 (VDD) et la borne 472 de référence du dispositif 400, une résistance R3401 et un condensateur C3405. Un première borne de la résistance R3401 est reliée, de préférence connectée, à la borne 476, et une deuxième de la résistance R3401 est reliée, de préférence connectée à une première borne du condensateur C3405. Un deuxième borne du condensateur C3405 est reliée, de préférence connectée, à la borne 472.

Le fonctionnement du système 3400 est le suivant. Au démarrage du système 3400, seule la borne 3401 alimente le système, mais une fois que les régulateurs de tension sont démarrés, les bornes 3401 et 478 alimentent le système, et la tension de sortie VOUT3400 se stabilise de la même manière que pour les systèmes 3200 et 3400.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

**Revendications**

1. Circuit de protection contre les surchauffes (454 ; 1800 ; 1900 ; 2100) formé dans et sur un substrat semiconducteur monolithique (101) ayant une face recouverte d'une couche de Nitrure de Gallium (102), comprenant :

   - une première résistance (R1802) ayant un premier coefficient de température positif et étant disposée dans ladite couche de Nitrure de Gallium ; et
   - une deuxième résistance (R1801) ayant un deuxième coefficient de température différent du premier coefficient.

2. Circuit selon la revendication 1, dans lequel la deuxième résistance (R1801) est disposée dans ledit substrat, et dans lequel ledit deuxième coefficient est égal à zéro.

3. Circuit selon la revendication 2, dans lequel la deuxième résistance (R1801) est disposée dans ladite couche de Nitrure de Gallium (102).

4. Circuit selon la revendication 1, dans lequel ledit deuxième coefficient est positif.

5. Circuit selon la revendication 1, dans lequel ledit deuxième coefficient est négatif.

6. Circuit selon l'une quelconque des revendications 1 à 5, dans lequel ladite deuxième résistance est en un alliage de Silicium et de Chrome.

7. Circuit selon l'une quelconque des revendications 1 à 6, comprenant, en outre un circuit comparateur (C1801) adapté à comparer une premier tension prise aux bornes de la première résistance (R1802) à une deuxième tension de référence (VREF1800).

8. Circuit selon la revendication 7, dans lequel la tension de référence (VREF1800) est adaptée à être fournie par un pont diviseur de tension.

9. Circuit selon l'une quelconque des revendications 1 à 8, dans lequel l'impédance de la première résistance (R1802) est adapté à être ajustée.

10. Circuit selon la revendication 9, dans lequel la première résistance (R1802) est formée par un circuit comprenant au moins un fusible (MF2101).

11. Dispositif électronique (400) formé dans et sur un substrat semiconducteur monolithique ayant une face recouverte d'une couche de Nitrure de Gallium, comprenant un circuit de protection contre les surchauffes selon l'une quelconque des revendications 1 à 10.

12. Dispositif selon la revendication 11, comprenant, en outre, au moins un transistor de puissance (401) HEMT de type e-mode adapté à recevoir une tension maximale de 650 V entre son drain et sa source.

13. Dispositif selon la revendication 12, dans lequel ledit transistor de puissance (401) est formée par au moins deux assemblages de transistors HEMT de type e-mode, et la première résistance (R1802) est formée entre deux desdits assemblages.

100

GaN

102

Si

101

**Fig. 1**

200

D

G

(A)

S

250

S

254

G

256

253

D

255

AlGaN

252

GaN

251

Si

(B)

**Fig. 2**

300

D

G

S

(A)

350

S

G

356

354

D

355

353

AlGaN

352 GaN

351 Si

(B)

# Fig. 3

**Fig. 4**

**Fig. 5**

500 · 501 · 502 · 503

DRAIN · SOURCE

500D · 500S · 500G

400

401 · 401 · 401 · 401

450

470 to 478

**Fig. 6**

**Fig. 7**

**Fig. 8**

**Fig. 9**

1000

VCC

R701

T801

T702

T701

T501

OUT501

VDD

DZ

| CIRC 1 | CIRC 2 | CIRC 3 |
|--------|--------|--------|

951

952

953

**Fig. 10**

1100

VCC

T1101

R1101

DZ

VOLT

REG

700

VDD

**Fig. 11**

**Fig. 12**

**Fig. 13**

**Fig. 14**

**Fig. 15**

Fig. 16

Fig. 17

**Fig. 18**

**Fig. 19**

Fig. 20

**Fig. 21**

Fig. 22

2200

2202 REG

OUTL2201

2201

OUTL2202

IN

LOGIC

SGND

T2201

R2201

INV2201

T2202

C2201

ON PULL-UP

N2201

VDD

T2204

DRAIN

T2203

T2205

401

**Fig. 23**

2300

2301 SOURCE

2302 GATE

2303 ACTIVE

2304 DRAIN

2303 ACTIVE

2302 GATE

2301 SOURCE

2311 2312 2313 2312 2314

DRAIN GATE SOURCE T2205

DRAIN GATE SOURCE T2205

401

**Fig. 24**

**Fig. 25**

**Fig. 26**

**Fig. 27**

**Fig. 28**

**Fig. 29**

**Fig. 30**

**Fig. 31**

**Fig. 32**

**Fig. 33**

Fig. 34

VOUT3300

V(IN-1)

V(IN-2)

I(L3301)

I(OUT)

time(us)

**Fig. 35**

**Fig. 36**